(19) Europäisches Patentamt
European Patent Office
Office européen des brevets

(11) **EP 1 490 975 B1**

(12) **EUROPEAN PATENT SPECIFICATION**

(45) Date of publication and mention of the grant of the patent:
**12.08.2009 Bulletin 2009/33**

(21) Application number: **03714994.5**

(22) Date of filing: **02.04.2003**

(51) Int Cl.:
***H03M 7/40*** $^{(2006.01)}$ ***H04N 7/50*** $^{(2006.01)}$

(86) International application number:
**PCT/FI2003/000253**

(87) International publication number:
**WO 2003/084076 (09.10.2003 Gazette 2003/41)**

(54) **CODING TRANSFORM COEFFICIENTS IN IMAGE / VIDEO ENCODER AND/OR DECODERS**

CODIERUNG VON TRANSFORMATIONSKOEFFIZIENTEN IN BILD-/VIDEOCODIERERN- UND/ ODER DECODIERERN

COEFFICIENTS DE TRANSFORMATION DE CODAGE UTILISES DANS DES CODEURS ET/OU DES DECODEURS D'IMAGE/VIDEO

(84) Designated Contracting States:
**AT BE BG CH CY CZ DE DK EE ES FI FR GB GR HU IE IT LI LU MC NL PT RO SE SI SK TR**

(30) Priority: **02.04.2002 US 369500 P**

(43) Date of publication of application:
**29.12.2004 Bulletin 2004/53**

(73) Proprietor: **Nokia Corporation**
**02150 Espoo (FI)**

(72) Inventors:
- **KURCEREN, Ragip**
  **Carollton, TX 75007 (US)**
- **KARCZEWICZ, Marta**
  **Irving, TX 75038 (US)**

(74) Representative: **Pursiainen, Timo Pekka**
**Tampereen Patenttitoimisto Oy**
**Hermiankatu 1 B**
**33720 Tampere (FI)**

(56) References cited:

| | |
|---|---|
| **GB-A- 2 267 410** | **GB-A- 2 332 127** |
| **US-A- 6 023 296** | **US-A- 6 166 664** |

- **MARPE D. ET AL: 'New Results on Improved CABAC' JOINT VIDEO TEAM OF ISO/IEC MPEG & ITU-T VCEG, JVT-B101 26 January 2002, pages 1 - 11**
- **KARCZEWICZ M.: 'vlc COEFFICIENTS CODING FOR HIGH BITRATE' JOINT VIDEO TEAM OF ISO/IEC MPEG&ITU-T VCEG, JVT-B072 29 January 2002,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Field of the Invention

The invention relates to a method, an encoder, a decoder and a device for the coding of digital video. More specifically, the invention concerns the coding of quantised transform coefficients, produced as a result of block-based transform coding in a video / image encoder / decoder, using Variable Length Coding (UVLC).

Background of the invention

Digital video sequences, like ordinary motion pictures recorded on film, comprise a sequence of still images, the illusion of motion being created by displaying the images one after the other at a relatively fast rate, typically 15 to 30 frames per second. Because of the relatively fast display rate, images in consecutive frames tend to be quite similar and thus contain a considerable amount of redundant information. For example, a typical scene may comprise some stationary elements, such as background scenery, and some moving areas, which may take many different forms, for example the face of a newsreader, moving traffic and so on. Alternatively, the camera recording the scene may itself be moving, for example, in which case all elements of the image have the same kind of motion. In many cases, this means that the overall change between one video frame and the next is rather small.

Each frame of an uncompressed digital video sequence comprises an array of image pixels. For example, in a commonly used digital video format, known as the Quarter Common Interchange Format (QCIF), a frame comprises an array of 176 x 144 pixels, in which case each frame has 25,344 pixels. In turn, each pixel is represented by a certain number of bits which carry information about the luminance and/or colour content of the region of the image corresponding to the pixel. Commonly, a so-called YUV colour model is used to represent the luminance and chrominance content of the image. The luminance, or Y, component represents the intensity (brightness) of the image, while the colour content of the image is represented by two chrominance or colour difference components, labelled U and V.

Colour models based on a luminance/chrominance representation of image content provide certain advantages compared with colour models that are based on a representation involving primary colours (that is Red, Green and Blue, RGB). The human visual system is more sensitive to intensity variations than it is to colour variations and YUV colour models exploit this property by using a lower spatial resolution for the chrominance components (U, V) than for the luminance component (Y). In this way, the amount of information needed to code the colour information in an image can be reduced with an acceptable reduction in image quality.

The lower spatial resolution of the chrominance components is usually attained by sub-sampling. Typically, each frame of a video sequence is divided into so-called "macroblocks", which comprise luminance (Y) information and associated chrominance (U, V) information which is spatially sub-sampled. Figure 3 illustrates one way in which macroblocks can be formed. Figure 3a shows a frame of a video sequence represented using a YUV colour model, each component having the same spatial resolution. Macroblocks are formed by representing a region of 16x6 image pixels in the original image (Figure 3b) as four blocks of luminance information, each luminance block comprising an 8x8 array of luminance (Y) values and two, spatially corresponding, chrominance components (U and V) which are sub-sampled by a factor of two in the x and y directions to yield corresponding arrays of 8x8 chrominance (U, V) values (see Figure 3c). According to certain video coding recommendations, such as International Telecommunications Union (ITU-T) recommendation H.26L, the block size used within the macroblocks can be other than 8x8, for example 4x8 or 4x4 (see Joint Model (JM) 2.0 Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002, Section 3.2)..

A OCIF image comprises 11x9 macroblocks. If the luminance blocks and chrominance blocks are represented with 8 bit resolution (that is by numbers in the range 0 to 255), the total number of bits required per macroblock is (16x16x8)+2x(8x8x8) = 3072 bits. The number of bits needed to represent a video frame in QCIF format is thus 99x3072 = 304,128 bits. This means that the amount of data required to transmit/record/display an uncompressed video sequence in QCIF format, represented using a YUV colour model, at a rate of 30 frames per second, is more than 9 Mbps (million bits per second). This is an extremely high data rate and is impractical for use in video recording, transmission and display applications because of the very large storage capacity, transmission channel capacity and hardware performance required.

If video data is to be transmitted in real-time over a fixed line network such as an ISDN (Integrated Services Digital Network) or a conventional PSTN (Public Switched Telephone Network), the available data transmission bandwidth is typically of the order of 64kbits/s. In mobile videotelephony, where transmission takes place at least in part over a radio communications link, the available bandwidth can be as low as 20kbits/s. This means that a significant reduction in the amount of information used to represent video data must be achieved in order to enable transmission of digital video sequences over low bandwidth communication networks. For this reason, video compression techniques have been developed which reduce the amount of information transmitted while retaining an acceptable image quality.

Video compression methods are based on reducing the redundant and perceptually irrelevant parts of video sequences. The redundancy in video sequences can be categorised into spatial, temporal and spectral redundancy. "Spatial redundancy" is the term used to describe the correlation (similarity) between neighbouring pixels within a frame. The term "temporal redundancy" expresses the fact that objects appearing in one frame of a sequence are likely to appear in subsequent frames, while "spectral redundancy" refers to the correlation between different colour components of the same image.

Sufficiently efficient compression cannot usually be achieved by simply reducing the various forms of redundancy in a given sequence of images. Thus, most current video encoders also reduce the quality of those parts of the video sequence which are subjectively the least important. In addition, the redundancy of the compressed video bit-stream itself is reduced by means of efficient loss-less encoding. Generally, this is achieved using a technique known as entropy coding.

There is often a significant amount of spatial redundancy between the pixels that make up each frame of a digital video sequence. In other words, the value of any pixel within a frame of the sequence is substantially the same as the value of other pixels in its immediate vicinity. Typically, video coding systems reduce spatial redundancy using a technique known as "block-based transform coding", in which a mathematical transformation, such as a two-dimensional Discrete Cosine Transform (DCT), is applied to blocks of image pixels. This transforms the image data from a representation comprising pixel values to a form comprising a set of coefficient values representative of spatial frequency components, significantly reducing spatial redundancy and thereby producing a more compact representation of the image data.

Frames of a video sequence which are compressed using block-based transform coding, without reference to any other frame within the sequence, are referred to as INTRA-coded or 1-frames. Additionally, and where possible, blocks of INTRA-coded frames are predicted from previously coded blocks within the same frame. This technique, known as INTRA-prediction, has the effect of further reducing the amount of data required to represent an INTRA-coded frame.

Generally, video coding systems not only reduce the spatial redundancy within individual frames of a video sequence, but also make use of a technique known as "motion-compensated prediction", to reduce the temporal redundancy in the sequence. Using motion-compensated prediction, the image content of some (often many) frames in a digital video sequence is "predicted" from one or more other frames in the sequence known as "reference" frames. Prediction of image content is achieved by tracking the motion of objects or regions of an image between a frame to be coded (compressed) and the reference frame(s) using "motion vectors". In general, the reference frame(s) may precede the frame to be coded or may follow it in the video sequence. As in the case of INTRA-coding, motion compensated prediction of a video frame is typically performed macroblock-by-macroblock.

Frames of a video sequence which are compressed using motion-compensated prediction are generally referred to as INTER-coded or P-frames. Motion-compensated prediction alone rarely provides a sufficiently precise representation of the image content of a video frame and therefore it is typically necessary to provide a so-called "prediction error" (PE) frame with each INTER-coded frame. The prediction error frame represents the difference between a decoded version of the INTER-coded frame and the image content of the frame to be coded. More specifically, the prediction error frame comprises values that represent the difference between pixel values in the frame to be coded and corresponding reconstructed pixel values formed on the basis of a predicted version of the frame in question. Consequently, the prediction error frame has characteristics similar to a still image and block-based transform coding can be applied in order to reduce its spatial redundancy and hence the amount of data (number of bits) required to represent it.

In order to illustrate the operation of a video coding system in greater detail, reference will now be made to Figures 1 and 2. Figure 1 is a schematic diagram of a generic video encoder that employs a combination of INTRA-and INTER-coding to produce a compressed (encoded) video bit-stream. A corresponding decoder is illustrated in Figure 2 and will be described later in the text.

The video encoder 100 comprises an input 101 for receiving a digital video signal from a camera or other video source (not shown). It also comprises a transformation unit 104 which is arranged to perform a block-based discrete cosine transform (DCT), a quantiser 106, an inverse quantiser 108, an inverse transformation unit 110, arranged to perform an inverse block-based discrete cosine transform (IDCT), combiners 112 and 116, and a frame store 120. The encoder further comprises a motion estimator 130, a motion field coder 140 and a motion compensated predictor 150. Switches 102 and 114 are operated co-operatively by control manager 160 to switch the encoder between an INTRA-mode of video encoding and an INTER-mode of video encoding. The encoder 100 also comprises a video multiplex coder 170 which forms a single bit-stream from the various types of information produced by the encoder 100 for further transmission to a remote receiving terminal or, for example, for storage on a mass storage medium, such as a computer hard drive (not shown).

Encoder 100 operates as follows. Each frame of uncompressed video provided from the video source to input 101 is received and processed macroblock by macroblock, preferably in raster-scan order. When the encoding of a new video sequence starts, the first frame to be encoded is encoded as an INTRA-coded frame. Subsequently, the encoder is programmed to code each frame in INTER-coded format, unless one of the following conditions is met: 1) it is judged that the current macroblock of the frame being coded is so dissimilar from the pixel values in the reference frame used in its prediction that excessive prediction error information is produced, in which case the current macroblock is coded in INTRA-coded format; 2) a predefined INTRA frame repetition interval has expired; or 3) feedback is received from a receiving terminal indicating a request for a frame to be provided in INTRA-coded format.

The occurrence of condition 1) is detected by monitoring the output of the combiner 116. The combiner 116 forms a difference between the current macroblock of the frame being coded and its prediction, produced in the motion compensated prediction block 150. If a measure of this difference (for example a sum of absolute differences of pixel values) exceeds a predetermined threshold, the combiner 116 informs the control manager 160 via a control line 119 and the control manager 160 operates the switches 102 and 114 via control line 113 so as to switch the encoder 100 into INTRA-coding mode. In this way, a frame which is otherwise encoded in INTER-coded format may comprise INTRA-coded macroblocks. Occurrence of condition 2) is monitored by means of a timer or frame counter implemented in the control manager 160, in such a way that if the timer expires, or the frame counter reaches a predetermined number of frames, the control manager 160 operates the switches 102 and 114 via control line 113 to switch the encoder into INTRA-coding mode. Condition 3) is triggered if the control manager 160 receives a feedback signal from, for example, a receiving terminal, via control line 121 indicating that an INTRA frame refresh is required by the receiving terminal. Such a condition may arise, for example, if a previously transmitted frame is badly corrupted by interference during its transmission, rendering it impossible to decode at the receiver. In this situation, the receiving decoder issues a request for the next frame to be encoded in INTRA-coded format, thus re-initialising the coding sequence.

Operation of the encoder 100 in INTRA-coding mode will now be described. In INTRA-coding mode, the control manager 160 operates the switch 102 to accept video input from input line 118. The video signal input is received macroblock by macroblock from input 101 via the input line 118. As they are received, the blocks of luminance and chrominance values which make up the macroblock are passed to the DCT transformation block 104, which performs a 2-dimensional discrete cosine transform on each block of values, producing a 2-dimensional array of DCT coefficients for each block. DCT transformation block 104 produces an array of coefficient values for each block, the number of coefficient values depending on the nature of the blocks which make up the macroblock. For example, if the fundamental block size used in the macroblock is 4x4, DCT transformation block 104 produces a 4x4 array of DCT coefficients for each block. If the block size is 8x8, an 8x8 array of DCT coefficients is produced.

The DCT coefficients for each block are passed to the quantiser 106, where they are quantised using a quantisation parameter QP. Selection of the quantisation parameter QP is controlled by the control manager 160 via control line 115. Quantisation introduces a loss of information, as the quantised coefficients have a lower numerical precision than the coefficients originally generated by the DCT transformation block 104. This provides a further mechanism by which the amount of data required to represent each image of the video sequence can be reduced. However, unlike the DCT transformation, which is essentially loss-less, the toss of information introduced by quantisation causes an irreversible degradation in image quality. The greater the degree of quantisation applied to the DCT coefficients, the greater the loss of image quality.

The quantised DCT coefficients for each block are passed from the quantiser 106 to the video multiplex coder 170, as indicated by line 125 in Figure 1. The video multiplex coder 170 orders the quantised transform coefficients for each block using a zigzag scanning procedure. This operation converts the two-dimensional array of quantised transform coefficients into a one-dimensional array. Typical zigzag scanning orders, such as that for a 4x4 array shown in Figure 4, order the coefficients approximately in ascending order of spatial frequency. This also tends to order the coefficients according to their values, such that coefficients positioned earlier in the one-dimensional array are more likely to have larger absolute values than coefficients positioned later in the array. This is because lower spatial frequencies tend to have higher amplitudes within the image blocks. Consequently, the last values in the one-dimensional array of quantised transform coefficients are commonly zeros.

Typically, the video multiplex coder 170 represents each non-zero quantised coefficient in the one-dimensional array by two values, referred to as *level* and *run. Level* is the value of the quantised coefficient and *run* is the number of consecutive zero-valued coefficients preceding the coefficient in question. The *run* and *level* values for a given coefficient are ordered such that the *level* value precedes the associated *run* value. A *level* value equal to zero is used to indicate that there are no more non-zero coefficient values in the block. This 0-*level value* is referred to as an EOB (end-of-block) symbol.

Alternatively, each non-zero-valued quantised coefficient in the one-dimensional array can be represented by 3 values (*run, level, last*). The meaning of *level* and *run* is identical to the previous scheme, whereas *last* denotes if there are any other non-zero-valued coefficients in the one-dimensional array following the current coefficient. Consequently, there is no need for a separate EOB symbol.

The *run* and *level* values (*last* if applicable) are further compressed using entropy coding. Entropy coding is a loss-less operation which exploits the fact that symbols within a data set to be coded generally have different probabilities of occurrence. Therefore, instead of using a fixed number of bits to represent each symbol, a variable number of bits is assigned such that symbols which are more likely to occur are represented by codewords having fewer bits. For this reason, entropy coding is often referred to as Variable Length Coding (VLC). Since certain values of *levels* and *runs* are more likely than other values to occur, entropy coding techniques can be used effectively to reduce the number of bits required to represent the *run* and *level* values.

Once the *run* and *level* values have been entropy coded, the video multiplex coder 170 further combines them with control information, also entropy coded using a variable length coding method appropriate for the kind of information in question, to form a single compressed bit-stream of coded image information 135. It is this bit-stream, including the variable length codewords representative of the (*run, level*) pairs, which is transmitted from the encoder.

While entropy coding has been described in connection with operations performed by the video multiplex coder 170, it should be noted that in alternative implementations a separate entropy coding unit may be provided.

A locally decoded version of the macroblock is also formed in the encoder 100. This is done by passing the quantised transform coefficients for each block, output by quantiser 106, through inverse quantiser 108 and applying an inverse DCT transform in inverse transformation block 110. In this way a reconstructed array of pixel values is constructed for each block of the macroblock. The resulting decoded image data is input to combiner 112. In INTRA-coding mode, switch 114 is set so that the input to the combiner 112 via switch 114 is zero. In this way, the operation performed by combiner 112 is equivalent to passing the decoded image data unaltered.

As subsequent macroblocks of the current frame are received and undergo the previously described encoding and local decoding steps in blocks 104, 106, 108, 110 and 112, a decoded version of the INTRA-coded frame is built up in frame store 120. When the last macroblock of the current frame has been INTRA-coded and subsequently decoded, the frame store 120 contains a completely decoded frame, available for use as a prediction reference frame in coding a subsequently received video frame in INTER-coded format.

Operation of the encoder 100 in INTER-coding mode will now be described. In INTER-coding mode, the control manager 160 operates switch 102 to receive its input from line 117, which comprises the output of combiner 116. The combiner 116 receives the video input signal macroblock by macroblock from input 101. As combiner 116 receives the blocks of luminance and chrominance values which make up the macroblock, it forms corresponding blocks of prediction error information. The prediction error information represents the difference between the block in question and its prediction, produced in motion compensated prediction blocks 150. More specifically, the prediction error information for each block of the macroblock comprises a two-dimensional array of values, each of which represents the difference between a pixel value in the block of luminance or chrominance information being coded and a decoded pixel value obtained by forming a motion-compensated prediction for the block, according to the procedure described below. Thus, in a situation where each macroblock comprises, for example, an assembly of 4x4 blocks comprising luminance and chrominance values the prediction error information for each block of the macroblock similarly comprises a 4x4 array of prediction error values.

The prediction error information for each block of the macroblock is passed to DCT transformation block 104, which performs a two-dimensional discrete cosine transform on each block of prediction error values to produce a two-dimensional array of DCT transform coefficients for each block. DCT transformation block 104 produces an array of coefficient values for each prediction error block, the number of coefficient values depending on the nature of the blocks which make up the macroblock. For example, if the fundamental block size used in the macroblock is 4x4, DCT transformation block 104 produces a 4x4 array of DCT coefficients for each prediction error block. If the block size is 8x8, an 8x8 array of DCT coefficients is produced.

The transform coefficients for each prediction error block are passed to quantiser 106 where they are quantised using a quantisation parameter QP, in a manner analogous to that described above in connection with operation of the encoder in INTRA-coding mode. Again, selection of the quantisation parameter QP is controlled by the control manager 160 via control line 115.

The quantised DCT coefficients representing the prediction error information for each block of the macroblock are passed from quantiser 106 to video multiplex coder 170, as indicated by line 125 in Figure 1. As in INTRA-coding mode, the video multiplex coder 170 orders the transform coefficients for each prediction error block using the previously described zigzag scanning procedure (see Figure 4) and then represents each non-zero quantised coefficient as a *level* and a *run* value. It further compresses the *run* and *level* values using entropy coding, in a manner analogous to that described above in connection with INTRA-coding mode. Video multiplex coder 170 also receives motion vector information (described in the following) from motion field coding block 140 via line 126 and control information from control manager 160. It entropy codes the motion vector information and control information and forms a single bit-stream of coded image information, 135 comprising the entropy coded motion vector, prediction error and control information.

The quantised DCT coefficients representing the prediction error information for each block of the macroblock are also passed from quantiser 106 to inverse quantiser 108. Here they are inverse quantised and the resulting blocks of inverse quantised DCT coefficients are applied to inverse DCT transform block 110, where they undergo inverse DCT transformation to produce locally decoded blocks of prediction error values. The locally decoded blocks of prediction error values are then input to combiner 112. In INTER-coding mode, switch 114 is set so that the combiner 112 also receives predicted pixel values for each block of the macroblock, generated by motion-compensated prediction block 150. The combiner 112 combines each of the locally decoded blocks of prediction error values with a corresponding block of predicted pixel values to produce reconstructed image blocks and stores them in frame store 120.

As subsequent macroblocks of the video signal are received from the video source and undergo the previously described encoding and decoding steps in blocks 104, 106, 108, 110, 112, a decoded version of the frame is built up in frame store 120. When the last macroblock of the frame has been processed, the frame store 120 contains a completely decoded frame, available for use as a prediction reference frame in encoding a subsequently received video frame in INTER-coded format.

Formation of a prediction for a macroblock of the current frame will now be described. Any frame encoded in INTER-coded format requires a reference frame for motion-compensated prediction. This means, necessarily, that when encoding a video sequence, the first frame to be encoded, whether it is the first frame in the sequence, or some other frame, must be encoded in INTRA-coded format. This, in turn, means that when the video encoder 100 is switched into INTER-coding mode by control manager 160, a complete reference frame, formed by locally decoding a previously encoded frame, is already available in the frame store 120 of the encoder. In general, the reference frame is formed by locally decoding either an INTRA-coded frame or an INTER-coded frame.

The first step in forming a prediction for a macroblock of the current frame is performed by motion estimation block 130. The motion estimation block 130 receives the blocks of luminance and chrominance values which make up the current macroblock of the frame to be coded via line 128. It then performs a block matching operation in order to identify a region in the reference frame which corresponds substantially with the current macroblock. In order to perform the block matching operation, motion estimation block accesses reference frame data stored in frame store 120 via line 127. More specifically, motion estimation block 130 performs block-matching by calculating difference values (e.g. sums of absolute differences) representing the difference in pixel values between the macroblock under examination and candidate best-matching regions of pixels from a reference frame stored in the frame store 120. A difference value is produced for candidate regions at all possible offsets within a predefined search region of the reference frame and motion estimation block 130 determines the smallest calculated difference value. The offset between the macroblock in the current frame and the candidate block of pixel values in the reference frame that yields the smallest difference value defines the motion vector for the macroblock in question.

Once the motion estimation block 130 has produced a motion vector for the macroblock, it outputs the motion vector to the motion field coding block 140. The motion field coding block 140 approximates the motion vector received from motion estimation block 130 using a motion model comprising a set of basis functions and motion coefficients. More specifically, the motion field coding block 140 represents the motion vector as a set of motion coefficient values which, when multiplied by the basis functions, form an approximation of the motion vector. Typically, a translational motion model having only two motion coefficients and basis functions is used, but motion models of greater complexity may also be used.

The motion coefficients are passed from motion field coding block 140 to motion compensated prediction block 150. Motion compensated prediction block 150 also receives the best-matching candidate region of pixel values identified by motion estimation block 130 from frame store 120. Using the approximate representation of the motion vector generated by motion field coding block 140 and the pixel values of the best-matching candidate region from the reference frame, motion compensated prediction block 150 generates an array of predicted pixel values for each block of the macroblock. Each block of predicted pixel values is passed to combiner 116 where the predicted pixel values are subtracted from the actual (input) pixel values in the corresponding block of the current macroblock. In this way a set of prediction error blocks for the macroblock is obtained.

Operation of the video decoder 200, shown in Figure 2 will now be described. The decoder 200 comprises a video multiplex decoder 270, which receives an encoded video bit-stream 135 from the encoder 100 and demultiplexes it into its constituent parts, an inverse quantiser 210, an inverse DCT transformer 220, a motion compensated prediction block 240, a frame store 250, a combiner 230, a control manager 260, and an output 280.

The control manager 260 controls the operation of the decoder 200 in response to whether an INTRA- or an INTER-coded frame is being decoded. An INTRA / INTER trigger control signal, which causes the decoder to switch between decoding modes is derived, for example, from picture type information associated with each compressed video frame received from the encoder. The INTRA / INTER trigger control signal is extracted from the encoded video bit-stream by the video multiplex decoder 270 and is passed to control manager 260 via control line 215.

Decoding of an INTRA-coded frame is performed on a macroblock-by-macroblock basis, each macroblock being decoded substantially as soon as encoded information relating to it is received in the video bit-stream 135. The video multiplex decoder 270 separates the encoded information for the blocks of the macroblock from possible control information relating to the macroblock in question. The encoded information for each block of an INTRA-coded macroblock comprises variable length codewords representing the entropy coded *level* and *run* values for the non-zero quantised DCT coefficients of the block. The video multiplex decoder 270 decodes the variable length codewords using a variable length decoding method corresponding to the encoding method used in the encoder 100 and thereby recovers the *level* and *run* values. It then reconstructs the array of quantised transform coefficient values for each block of the macroblock and passes them to inverse quantiser 210. Any control information relating to the macroblock is also decoded in the video multiplex decoder using an appropriate decoding method and is passed to control manager 260. In particular, information relating to the level of quantisation applied to the transform coefficients is extracted from the encoded bit-stream by video multiplex decoder 270 and provided to control manager 260 via control line 217. The control manager, in turn, conveys this information to inverse quantiser 210 via control line 218. Inverse quantiser 210 inverse quantises the quantised DCT coefficients for each block of the macroblock according to the control information and provides the now inverse quantised DCT coefficients to inverse DCT transformer 220.

Inverse DCT transformer 220 performs an inverse DCT transform on the inverse quantised DCT coefficients for each block of the macroblock to form a decoded block of image information comprising reconstructed pixel values. The reconstructed pixel values for each block of the macroblock are passed via combiner 230 to the video output 280 of the decoder where, for example, they can be provided to a display device (not shown). The reconstructed pixel values for each block of the macroblock are also stored in frame store 250. Because motion-compensated prediction is not used in the encoding/decoding of INTRA coded macroblocks control manager 260 controls combiner 230 to pass each block of pixel values as such to the video output 280 and frame store 250. As subsequent macroblocks of the INTRA-coded frame are decoded and stored, a decoded frame is progressively assembled in the frame store 250 and thus becomes available for use as a reference frame for motion compensated prediction in connection with the decoding of subsequently received INTER-coded frames.

INTER-coded frames are also decoded macroblock by macroblock, each INTER-coded macroblock being decoded substantially as soon as encoded information relating to it is received in the bit-stream 135. The video multiplex decoder 270 separates the encoded prediction error information for each block of an INTER-coded macroblock from encoded motion vector information and possible control information relating to the macroblock in question. As explained in the foregoing, the encoded prediction error information for each block of the macroblock comprises variable length codewords representing the entropy coded *level* and *run* values for the non-zero quantised transform coefficients of the prediction error block in question. The video multiplex decoder 270 decodes the variable length codewords using a variable length decoding method corresponding to the encoding method used in the encoder 100 and thereby recovers the *level* and *run* values. It then reconstructs an array of quantised transform coefficient values for each prediction error block and passes them to inverse quantiser 210. Control information relating to the INTER-coded macroblock is also decoded in the video multiplex decoder 270 using an appropriate decoding method and is passed to control manager 260. Information relating to the level of quantisation applied to the transform coefficients of the prediction error blocks is extracted from the encoded bit-stream and provided to control manager 260 via control line 217. The control manager, in turn, conveys this information to inverse quantiser 210 via control line 218. Inverse quantiser 210 inverse quantises the quantised DCT coefficients representing the prediction error information for each block of the macroblock according to the control information and provides the now inverse quantised DCT coefficients to inverse DCT transformer 220. The inverse quantised DCT coefficients representing the prediction error information for each block are then inverse transformed in the inverse DCT transformer 220 to yield an array of reconstructed prediction error values for each block of the macroblock.

The encoded motion vector information associated with the macroblock is extracted from the encoded video bit-stream 135 by video multiplex decoder 270 and is decoded. The decoded motion vector information thus obtained is passed via control line 225 to motion compensated prediction block 240, which reconstructs a motion vector for the macroblock using the same motion model as that used to encode the INTER-coded macroblock in encoder 100. The reconstructed motion vector approximates the motion vector originally determined by motion estimation block 130 of the encoder. The motion compensated prediction block 240 of the decoder uses the reconstructed motion vector to identify the location of a region of reconstructed pixels in a prediction reference frame stored in frame store 250. The reference frame may be, for example, a previously decoded INTRA-coded frame, or a previously decoded INTER-coded frame. In either case, the region of pixels indicated by the reconstructed motion vector is used to form a prediction for the macroblock in question. More specifically, the motion compensated prediction block 240 forms an array of pixel values for each block of the macroblock by copying corresponding pixel values from the region of pixels identified in the reference frame. The prediction, that is the blocks of pixel values derived from the reference frame, are passed from motion compensated prediction block 240 to combiner 230 where they are combined with the decoded prediction error information. In practice, the pixel values of each predicted block are added to corresponding reconstructed prediction error values output by inverse DCT transformer 220. In this way an array of reconstructed pixel values for each block of the macroblock is obtained. The reconstructed pixel values are passed to the video output 280 of the decoder and are also stored in frame store 250.

As subsequent macroblocks of the INTER-coded frame are decoded and stored, a decoded frame is progressively assembled in the frame store 250 and thus becomes available for use as a reference frame for motion-compensated prediction of other INTER-coded frames.

Entropy coding of the *run* and *level* values associated with the quantised transform coefficients using the technique of variable length coding (VLC) will now be examined in greater detail.

Typically, a *run-level* pair is encoded as a single symbol. This is achieved by defining a mapping between each possible *run-level* pair and the defined code numbers. An example of a mapping of *run-level* pairs to code numbers as a look up table, is illustrated in Table 3. Using the mappings in the look-up table, a code number is assigned to each (*run, level*) pair of the block and the resulting code numbers are encoded by VLC coding. For example, in Joint Model (JM) 2.0 Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002, (H.26L video coding standard) two different look-up tables are defined that map the (*run, level*) pairs onto code numbers. The selection of which table is to be used is based on the QP value and the coding mode of the block. More specifically, if the coding mode is INTRA and the QP is smaller than 24, a different table is used than otherwise.

Joint Model JM 2.0 of JVT H.26L makes use of a so-called "universal variable length coding scheme, referred to as UVLC. Accordingly, a video encoder implemented according to H.26L JM 2.0 uses a single set of variable length codewords to entropy code all information (syntax elements) to be transmitted in the bit-stream from the encoder. While the codewords used are the same, a predetermined number of different data-symbol-to-codeword mappings are defined for the coding of different types of information. For example, two data-symbol-to-codeword mappings are provided for blocks containing luminance information, the choice of mapping depending on the type of zigzag scanning operation (simple or double scan) used to order the quantised DCT transform coefficients. For details of the simple and double scan zigzag scanning schemes defined according to H.26L, see Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002. Different mappings are also provided for macroblock type (MB_Type) information, motion vector data (MVD) and INTRA-prediction mode information, among others (see Table 3, below).

The UVLC codewords defined in H.26L JM 2.0 may be written in the following compressed form, shown in Table 1 below, where the $x_n$ terms can take either the value 0 or 1:

$$1$$
$$0\ 1\ x_0$$
$$0\ 0\ 1\ x_1\ x_0$$
$$0\ 0\ 0\ 1\ x_2\ x_1\ x_0$$
$$0\ 0\ 0\ 0\ 1\ x_3\ x_2\ x_1\ x_0$$
$$\cdots\cdots\cdots$$

**Table 1: Scheme for Generation of UVLC Codewords According to H.26L JM 2.0**

Table 2 presents the first 16 UVLC codewords, generated according to the scheme presented in Table 1, while Table 3 shows some of the different data-symbol-to-codeword mappings provided according to H.26L. For a complete description of the mappings, the reader should again refer to Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002.

Table 2: The First 16 UVLC Codewords of H.26L JM 2.0 Generated According to the Scheme Presented in Table 1

| Codeword index | VLC Codeword |
|---|---|
| 0 | 1 |
| 1 | 010 |
| 2 | 011 |
| 3 | 00100 |
| 4 | 00101 |
| 5 | 00110 |

(continued)

| Codeword index | VLC Codeword |
|---|---|
| 6 | 00111 |
| 7 | 0001000 |
| 8 | 0001001 |
| 9 | 0001010 |
| 10 | 000010000 |
| 11 | 000010001 |
| 12 | 000010010 |
| 13 | 000010011 |
| 14 | 000010100 |
| 15 | 000010101 |
| .... | .... |

Table 3: Example Data-Symbol-to-UVLC-Codeword Mappings as Defined in H.26L TML-5

| Code_ number | MB_Type | | INTRA_ prediction_ mode | | MVD | Tcoeff_chroma_AC Tcoeff_luma Simple scan | | Tcoeff_luma Double scan | |
|---|---|---|---|---|---|---|---|---|---|
| | INTRA | INTER | Prob0 | Prob1 | | Level | Run | Level | Run |
| 0 | Intra4x4 | Skip | 0 | 0 | 0 | EOB | - | EOB | - |
| 1 | 0,0,0[3] | 16x16 | 1 | 0 | 1 | 1 | 0 | 1 | 0 |
| 2 | 1,0,0 | 8x8 | 0 | 1 | -1 | -1 | 0 | -1 | 0 |
| 3 | 2,0,0 | 16x8 | 0 | 2 | 2 | 1 | 1 | 1 | 1 |
| 4 | 3,0,0 | 8x16 | 1 | 1 | -2 | -1 | 1 | -1 | 1 |
| 5 | 0,1,0 | 8x4 | 2 | 0 | 3 | 1 | 2 | 2 | 0 |
| 6 | 1,1,0 | 4x8 | 3 | 0 | -3 | -1 | 2 | -2 | 0 |
| 7 | 2,1,0 | 4x4 | 2 | 1 | 4 | 2 | 0 | 1 | 2 |
| 8 | 3,1,0 | Intra4x4 | 1 | 2 | -4 | -2 | 0 | -1 | 2 |
| 9 | 0,2,0 | 0,0,0[3] | 0 | 3 | 5 | 1 | 3 | 3 | 0 |
| 10 | 1,2,0 | 1,0,0 | 0 | 4 | -5 | -1 | 3 | -3 | 0 |
| 11 | 2,2,0 | 2,0,0 | 1 | 3 | 6 | 1 | 4 | 4 | 0 |
| 12 | 3,2,0 | 3,0,0 | 2 | 2 | -6 | -1 | 4 | -4 | 0 |
| 13 | 0,0,1 | 0,1,0 | 3 | 1 | 7 | 1 | 5 | 5 | 0 |
| 14 | 1,0,1 | 1,1,0 | 4 | 0 | -7 | -1 | 5 | -5 | 0 |
| 15 | 2,0,1 | 2,1,0 | 5 | 0 | 8 | 3 | 0 | 1 | 3 |
| 16 | 3,0,1 | 3,1,0 | 4 | 1 | -8 | -3 | 0 | -1 | 3 |
| 17 | 0,1,1 | 0,2,0 | 3 | 2 | 9 | 2 | 1 | 1 | 4 |
| 18 | 1,1,1 | 1,2,0 | 2 | 3 | -9 | -2 | 1 | -1 | 4 |
| 19 | 2,1,1 | 2,2,0 | 1 | 4 | 10 | 2 | 2 | 2 | 1 |
| 20 | 3,1,1 | 3,2,0 | 0 | 5 | -10 | -2 | 2 | -2 | 1 |
| 21 | 0,2,1 | 0,0,1 | 1 | 5 | 11 | 1 | 6 | 3 | 1 |
| 22 | 1,2,1 | 1,0,1 | 2 | 4 | -11 | -1 | 6 | -3 | 1 |
| 23 | 2,2,1 | 2,0,1 | 3 | 3 | 12 | 1 | 7 | 6 | 0 |
| 24 | 3,2,1 | 3,0,1 | 4 | 2 | -12 | -1 | 7 | -6 | 0 |
| 25 | | 0,1,1 | 5 | 1 | 13 | 1 | 8 | 7 | 0 |
| 26 | | 1,1,1 | 5 | 2 | -13 | -1 | 8 | -7 | 0 |
| 27 | | 2,1,1 | 4 | 3 | 14 | 1 | 9 | 8 | 0 |

(continued)

| Code_ number | MB_Type | | INTRA_ prediction_ mode | | MVD | Tcoeff_chroma_AC Tcoeff_luma Simple scan | | Tcoeff_luma Double scan | |
|---|---|---|---|---|---|---|---|---|---|
| | INTRA | INTER | Prob0 | Prob1 | | Level | Run | Level | Run |
| 28 | | 3,1,1 | 3 | 4 | -14 | -1 | 9 | -8 | 0 |
| 29 | | 0,2,1 | 2 | 5 | 15 | 4 | 0 | 9 | 0 |
| 30 | | 1,2,1 | 3 | 5 | -15 | -4 | 0 | -9 | 0 |
| 31 | | 2,2,1 | 4 | 4 | 16 | 5 | 0 | 10 | 0 |
| 32 | | 3,2,1 | 5 | 3 | -16 | -5 | 0 | -10 | 0 |
| 33 | | | 5 | 4 | 17 | 3 | 1 | 4 | 1 |
| 34 | | | 4 | 5 | -17 | -3 | 1 | -4 | 1 |
| 35 | | | 5 | 5 | 18 | 3 | 2 | 2 | 2 |
| 36 | | | | | -18 | -3 | 2 | -2 | 2 |
| 37 | | | | | 19 | 2 | 3 | 2 | 3 |
| 38 | | | | | -19 | -2 | 3 | -2 | 3 |
| 39 | | | | | 20 | 2 | 4 | 2 | 4 |
| 40 | | | | | -20 | -2 | 4 | -2 | 4 |
| 41 | | | | | 21 | 2 | 5 | 2 | 5 |
| 42 | | | | | -21 | -2 | 5 | -2 | 5 |
| 43 | | | | | 22 | 2 | 6 | 2 | 6 |
| 44 | | | | | -22 | -2 | 6 | -2 | 6 |
| 45 | | | | | 23 | 2 | 7 | 2 | 7 |
| 46 | | | | | -23 | -2 | 7 | -2 | 7 |
| 47 | | | | | 24 | 2 | 8 | 11 | 0 |

The universal variable length coding scheme adopted in H.26L provides a number of technical advantages. In particular, use of a single set of VLC codewords, which can be constructed according to a simple rule, such as that presented in Table 1, enables codewords to be created bit-by-bit. This obviates the need for storage of a codeword table in the encoder and decoder and thus reduces the memory requirements of both the encoder and decoder. It should be noted, of course, that in alternative implementations, codeword tables may be generated and stored in the encoder and decoder. The different data-symbol-to-codeword mappings allow at least limited adaptation of the UVLC coding scheme to the different statistical properties of the various types of image-related data and control information that are entropy coded. The various data-symbol-to-codeword mappings can be stored in the encoder and decoder and thus there is no need to transmit the mapping information in the bit-stream from encoder to decoder. This helps maintain error resilience.

The UVLC entropy coding scheme does, however, also suffer from some disadvantages. In particular, the fixed codewords and the limited degree of adaptability provided by the different data-symbol-to-codeword mappings, inevitably result in less than optimum data compression. This is due to the fact that, in image coding, the frequency of occurrence (i.e. probability) of different transform coefficients, and hence the probability of different (*run, level*) pairs, changes depending on the image content and the type of the image being encoded. Thus, if a single set of variable length codewords is used and only a single mapping between the data symbols to be encoded/decoded and the VLCs is provided, in general, optimum coding efficiency cannot be achieved.

For this reason modifications of the basic UVLC coding scheme have been proposed. More specifically, it has been suggested to include more than one set of VLC codewords. One such proposal was made by Gisle Bjontegaard in Q.15/SG16 "Use of Adaptive Switching Between Two VLCs for INTRA Luma Coefficients", Doc. Q15-K-30, August 2000. This proposal suggested the use of a second set of VLC codewords for the entropy coding of certain types of information. According to document Q15-K-30, the proposed second set of VLC codewords, referred to as VLC2, is constructed according to the scheme shown below in Table 4. It is used in particular to code the *run* and *level* values associated with quantised transform coefficients of 4x4 pixel INTRA-coded luminance blocks scanned using the double scan zigzag scanning scheme defined according to H.26L. Table 5 shows, in explicit form, the first 16 codewords of VLC2.

.

1 0

1 1 0

1 1 1

0 1 $x_1$ $x_0$

0 0 1 $x_2$ $x_1$ $x_0$

0 0 0 1 $x_3$ $x_2$ $x_1$ $x_0$

.........................................

**Table 4: Scheme for Generation of VLC2 Codewords According to Q.15/SG16 Document Q15-K-30**

Table 5: The First 16 VLC2 Codewords of Q.15/SG16 Document Q15-K-30, Generated According to the Scheme Presented in Table 4

| Codeword Index | VLC2 Codeword |
|---|---|
| 0 | 10 |
| 1 | 110 |
| 2 | 111 |
| 3 | 0100 |
| 4 | 0101 |
| 5 | 0110 |
| 6 | 0111 |
| 7 | 001000 |
| 8 | 001001 |
| 9 | 001010 |
| 10 | 001011 |
| 11 | 001100 |
| 12 | 001101 |
| 13 | 001110 |
| 14 | 001111 |
| 15 | 00010000 |

As can be seen by comparing Tables 4 and 5 with Tables 1 and 2 respectively, the shortest codeword of VLC2 has two bits as opposed to the single bit allocated to the shortest codeword in the original set of UVLC codewords. Due to the general decodability requirement that no VLC codeword may be a prefix of any other, this change has a significant effect on the structure of the other VLC2 codewords. In particular, assigning two bits to the shortest codeword enables codewords having higher indices to be represented with fewer bits. For example, referring to Table 2, it can be seen that the UVLC codeword with index 7 has 7 bits, while the VLC2 codeword with index 7 has only 6 bits.

It has also been observed that there is strong correlation between the number of non-zero coefficients within a block and the (*run, level*) pairs possible in the same block. Notice that the number of non-zero coefficients in a block is bounded by the transform block size, e.g. by 16 for a 4x4 transform. Likewise, the value of *run* is bounded by the transform block size, e.g. by 15 for 4x4 transform. When the number of non-zero coefficients is large, say close to the total size of the array, it is observed that (*run, level*) pairs with small value of *run* and high value of *level* have higher probability. For example, for a 4x4 transform with 15 non-zero coefficients, *run* can only take values in the range [0,1].

Based on these observations, the proposal made by Karczewicz, "VLC Coefficients Coding for High Bit-Rate", Doc. JVT-B072, 2nd JVT Meeting, Geneva, CH, Jan. 29 - Feb. 1, 2002 suggested a method of variable length coding in which a separate look-up table is provided corresponding to different numbers of non-zero-valued quantised transform coefficients. According to this proposal, the codewords and the mappings between the (*run, level*) pairs and the codewords for each one of the tables are designed to provide optimum data compression when applied to a set of (*run*, *level*) pairs derived from an array of quantised transform coefficient values having a specified number of non-zero-valued coefficients. Information about the variation of the statistical properties of the (*run, level*) pairs with respect to the number of non-zero-valued quantised transform coefficients is obtained empirically, for example, by coding a number of test ("training") images or video sequences in advance. The VLC codewords and the mappings between the codewords can then be designed and stored as one or more look-up table in the encoder.

The specifics of the algorithm proposed by Karczewicz are as follows: After a block of image pixels or prediction error values has been transform coded to form a two-dimensional array of transform coefficient values and each of the coefficient values has been quantised, the number of non-zero quantised coefficient values in the array Is determined. A value, referred to as $N_c$, Is assigned to that number and is used to signal explicitly the number of non-zero coefficient values in the array. Thus, an EOB symbol (for example a *level* value equal to zero) is no longer required. Then, each (*run*, *level*) pair in the block in question Is mapped onto codewords using a took-up table that defines the mapping between the (*run*, *level*) pairs and the codewords, the look-up table being selected In dependence on the $N_c$ value,

Both the previously described methods of VLC coding, in which codewords are selected by context-based switching between more than one set of codewords, provide an Improvement in data compression efficiency compared with methods in which a single set of VLC codewords is used. However, in many data compression applications, and particularly in applications related to video coding, there is a continuing desire to improve data compression efficiency. Thus, there is still considerable interest in the development of new methods of variable length coding which provide improved adaptability to the type and statistical properties of the data symbols to be coded while maintaining low computational complexity, low memory requirements and good error resilience. It is in this context that the method according to the present invention has been developed.

The document Kurceren R. et al: "New Results on Improved CABAC"; Doc, JVT-B101, 2nd Meeting, Geneva 29.01 - 01.02.2002 relates to a Context-based Adaptive Binary Arithmetic Coder (CABAC) and discloses new results on improved CABAC. New coding elements and new context models are proposed in the document for improving coding efficiency of the CABAC. This is achieved by introducing an additional coding element, called COEFF COUNT, which denotes the numbers of non-zero coefficients in a given block. The document also-proposes to exploit the given inter-symbol redundancies in transform coding in a more efficient way by using appropriately defined context models. The new coding elements COEFF COUNT is used In the encoding of the RUN element.

For encoding the RUN, the information of the initially encoded COEFF COUNT and all previously encoded RUN elements of a block are exploited. This information is utilized to truncate the binarization of the RUN element (Truncated Binarization). According to Kurceren et al., if there are 10 non-zero coefficients in a 4x4 single scan block, then, at the beginning of the encoding of the RUN element it is known that the maximum value of RUN (MaxRun is 6 (=16-10). The maximum value or RUN is updated after every loop of the encoding process. When the maximum value of RUN indicates that no more non-zero-valued RUN elements can exist in the current block, the encoding of the RUN elements can be stopped. Therefore, in some cases signalling of zero-valued RUN elements is completely omitted, particularly when zero-valued runs occur at the end of the block (sequence) of RUN values to be encoded, It should be appreciated that this adaptation based on MaxRun truncates, i.e shortens, the coding Process and does not affect the probabilities assigned to each successive RUN element that is encoded. It should be emphasised that according to Kurceren et al., all-the RUN elements of a block are encoded together as a single code word representing a decimal value between 0 and 1. By using truncation, the number of decimals in the code word could be less than in a code word generated without truncation.

## Summary of the Invention

The invention relates in general to the variable length coding of data symbols represented as (*run*, *level*) pairs. It involves the use of at least two mappings between data symbols and VLC codewords and defines rules for switching between the mappings, which take into account the statistical properties of the data symbols to be variable length coded. In this way Improved data compression efficiency is obtained compared with VLC coding methods that use fixed mappings between data symbols and codewords. The switching rules are designed so that a bit-stream comprising VLC codewords formed according to the inventive method can be decoded without requiring any information relating to the choice of mapping to be included in the bit-stream. In other words, there is no need to provide an explicit indication of the mapping used to generate each codeword in the bit-stream. This property enhances data compression efficiency.

In particular, the present invention proposes new methods for the coding of quantised transform coefficients to improve coding efficiency. More specifically, a particular aim of the invention is to provide new and more efficient schemes for the coding of (*run, level*) pairs representing non-zero-valued quantised transform coefficients. Like the method proposed by Karczewicz in the document "VLC Coefficients Coding for High Bit-Rate", Doc. JVT-B072, 2nd JVT Meeting, Geneva, CH, Jan. 29 - Feb. 1, 2002, the present invention is based on the observation that the number of non-zero-valued coefficients in a block of transform coefficients, as well as the value of *run* is bounded by the transform block size. This observation and further analysis of encoders operating on real-world images demonstrate that there is a correlation between the number of non-zero coefficients in a block and the *run* values of the block in question. In particular, as more and more (*run, level*) pairs are encoded from a block, the possible number of *run-level* combinations starts decreasing.

Thus, the VLC encoding method according to the invention takes into account the fact that as successive (*run, level*) pairs are assigned to codewords, the possible range of *run* values associated with the next (*run, level*) pair to be coded becomes more limited.

The fact that the possible values for *run* change with each encoding of a (*run, level*) pair can be used advantageously during index assignment of (*run, level*) pairs to code numbers.

More specifically, according to an embodiment of the invention, at least two sets of mappings are provided for relating the (*run, level*) pairs to the code numbers. Each (*run, level*) pair is first mapped to a code number using the mapping table selected from one of the at least two sets of mappings responsive to the value of *max_run,* which defines the maximum value a *run* can take. *Max_run* Is Initialized by considering the number of non-zero-valued coefficients within the block and Is updated after encoding of each (*run, level*) pair. The following example Illustrates the point:

Assume that a block of quantised transform coefficients has 5 non-zero coefficients with (*run, level*) pairs (2.1), (3,2), (4,3). (2,3) and (1,2). It should be noted here that normally the run and level values for a given coefficient are ordered so that the level value precedes the associated run value. Hence, in the (run, level) pairs presented above the level values are the first numbers of each pair (2, 3, 4, 2, 1), and the run values are the last numbers of each pair (1. 2. 3, 3, 2). At the beginning of the encoding process, since there are 5 non-zero coefficients and there can be at most 18 such coefficients, *run* can take a value of at most 11. Denoting this maximum possible *run* value as *max_run,* it can be seen that after encoding the first (*run, level*) pair, that is (2,1), *max-run* will decrease, precisely it will become 10, found by updating the previous *max_run* value, by subtracting the current *run* value. More specifically, *max_run* is updated by:

$$max_run = max_run - run$$

where *max_run* is initialized by 18 - $N_c$ at the beginning of encoding of the block.

According to a first aspect of the invention, there Is provided a method of encoding a set of data symbols as defined by claim 1.

According to a second aspect of the invention, there is provided a method of decoding a set of codewords as defined by claim 10.

According to a third aspect of the invention, there is provided an encoder for encoding a set of data symbols as defined by claim 19.

According to a fourth aspect of the invention, there is provided a decoder for decoding a set of codewords as defined by claim 28.

According to a fifth aspect of the invention, there is provided a multimedia terminal comprising an encoder according the third aspect of the invention.

According to a sixth aspect of the invention, there is provided a multimedia terminal comprising a decoder according to the fourth aspect of the invention.

Preferably, the multimedia terminal according to the fifth and / or sixth aspects of the invention is a mobile multimedia terminal arranged to communicate with a mobile telecommunications network by means of a radio connection.

Brief Description of the Drawings

Embodiments of the invention will now be described by example with reference to the appended drawings, in which:

Figure 1 is a schematic block diagram of a generic video encoder according to prior art;

Figure 2 is a schematic block diagram of a generic video decoder according to prior art and corresponding to the encoder shown in Figure 1;

Figure 3 illustrates the formation of a macroblock according to prior art;

Figure 4 illustrates an exemplary zigzag scanning order;

Figure 5 is a schematic block diagram of a video encoder according to an embodiment of the invention;

Figure 6 is a schematic block diagram of a video decoder according to an embodiment of the invention and corresponding to the encoder shown in Figure 5; and

Figure 7 is a schematic block diagram of a multimedia communications terminal in which the method according to the invention may be implemented.

Detailed Description of the Invention

In the detailed description which follows, exemplary embodiments of the invention are presented. These relate to the variable length coding of (*run*, *level*) pairs representing non-zero-valued transform coefficients produced as a result of block-based transform coding in a video encoder, as well as their subsequent decoding in a corresponding video decoder. However, those skilled in the art will appreciate that the method according to the invention can be applied in general to the VLC coding of data symbols which are represented as (*run, level*) pairs or to any equivalent representation of a set of data symbols to be encoded.

Figure 5 is a schematic block diagram of a video encoder 600 in which the VLC encoding method according to the invention may be applied. The structure of the video encoder shown in Figure 5 is substantially identical to that of the prior art video encoder shown in Figure 1, with appropriate modifications to those parts of the encoder that perform variable length coding operations. All parts of the video encoder that implement functions and operate in a manner identical to the previously described prior art video encoder are identified with identical reference numbers. In this description it will be assumed that all variable length coding operations are performed in video multiplex coder 670. However, it should be appreciated that in alternative embodiments of the invention a separate variable length coding unit or units may be provided. It should also be noted that the method according to the invention may be applied to certain of the data symbols produced by the video encoder (e.g. the (*run, level*) pairs associated with non-zero-valued transform coefficients) and other VLC coding methods may be used to encode other data symbols.

Operation of the video encoder 600 will now be considered in detail. When encoding a frame of digital video, encoder 600 operates in a manner similar to that previously described in connection with Figure 1 to generate INTRA-coded and INTER-coded compressed video frames. As explained earlier in the text, in INTRA-coding mode, a Discrete Cosine Transform (DCT) is applied to each block of image data (pixel values) in order to produce a corresponding two-dimensional array of transform coefficient values. The DCT operation is performed in transform block 104 and the coefficients thus produced are subsequently passed to quantiser 106, where they are quantised. In INTER-coding mode, the DCT transform performed in block 104 is applied to blocks of prediction error values. The transform coefficients produced as a result of this operation are also passed to quantiser 106 where they too are quantised.

It should be noted that INTER-coded frames may contain INTRA-coded image blocks and furthermore that, in some situations, transform coding is not applied to particular image blocks. For example, if INTRA-prediction is used in INTRA-coding mode, some image blocks are predicted in the encoder from one or more previously encoded image block. In this case, the encoder provides the decoder with an indication of the previous blocks to be used in the prediction and does not output any transform coefficient data. Furthermore, in INTER-coding mode, the difference between the prediction for a certain block and the image data of the block itself may be so small that it is advantageous in terms of data compression ratio not to transmit any prediction error information. Accordingly, the VLC encoding method according to the invention is applied to those image blocks that undergo transform coding and subsequent transform coefficient quantisation.

According to the invention, when video multiplex coder 670 receives a block (two-dimensional array) of quantised transform coefficients, it determines the number of non-zero-valued coefficients in the array, $N_c$ and an indication of this number is transmitted to the decoder in bit-stream 635. In a preferred embodiment of the invention $N_c$ is variable length coded prior to transmission. In alternative embodiments, it may be transmitted as such or another coding method may be applied.

The video multiplex coder 670 next represents the non-zero-valued coefficients as (*run, level*) pairs. More specifically, the two-dimensional array of quantised transform coefficients is first scanned using a predefined scanning order, such as that shown in Figure 4, to produce an ordered one-dimensional array. Each non-zero-valued coefficient value in the ordered one-dimensional array is then represented by a *run* value and a *level* value, where the *level* value represents the value of the coefficient and the *run* value represents the number of consecutive zero-valued coefficients preceding the non-zero-valued coefficient.

The video multiplex coder 670 then applies variable length coding to the *run* and *level* values in such a way that a single VLC codeword is assigned to each (*run, level*) pair. According to a preferred embodiment of the invention, the (*run, level*) pairs are encoded by selecting a different mapping of (*run, level*) pairs into code numbers, considering the maximum *run* (denoted as *max_run*) possible before encoding the symbol. When encoding the first (*run, level*) pair in a block of quantised transform coefficients, *max_run* is set equal to the maximum possible number of non-zero-valued coefficients that can be present in a block, minus the value of $N_c$ previously determined. Thus for a 4x4 block, *max_run* is initialised as:

$$max_run = 16 - N_c \qquad (1)$$

The following exemplary pseudo-code provides one procedure for assigning a codeword to a *(run, level)* pair according to the invention:

$$Index_RL = RL_index[max_run, level, run]; \qquad (2)$$

where RL_index maps integer values of *run-level* values to different code numbers depending on the *max_run* value. It is initialized after running simulations using training material. Finally, Index_RL is encoded with one of the VLC codewords listed in Table 2 or Table 5.

More specifically, mapping function RL_Index is constructed empirically from one or more test sequences of video data by analysing the probability of occurrence of different (*run, level*) pairs for each possible value of *max_run.* Code numbers (i.e. the Index_RL values) generated by applying the mapping procedure are then used to select codewords representative of the (*run, level*) pairs from a codeword table. Preferred embodiments of the invention use either the codeword table shown above in Table 2 or that shown in Table 5.

Tables 6 and 7 present example mappings of (*run, level*) pairs to code numbers according to the *max_run* value. In both tables the rows correspond to *level* values and the columns correspond to *run* values, while the entries in each cell indicate the code number of the VLC codeword for that particular *run-level* pair (i.e. combination of *run* and *level* values). The most probable pair is assigned code number 1, the second most probable pair code number 2, etc. Both Table 6 and Table 7 list the first 15 most probable pairs. Table 6 illustrates the case where *max_run* is 8, while Table 7 shows the situation when *max_run* is 3.

Table 6: *max_run* = 8.

| | Run | | | | | | | | |
|---|---|---|---|---|---|---|---|---|---|
| Level | 1 | 2 | 3 | 4 | 6 | 7 | 8 | 11 | 12 |
| | 5 | 10 | 13 | 15 | | | | | |
| | 9 | | | | | | | | |
| | 14 | | | | | | | | |

Table 7: *max_run* = 3.

| | Run | | | |
|---|---|---|---|---|
| Level | 1 | 3 | 5 | 9 |
| | 2 | 7 | 12 | |
| | 4 | 10 | | |
| | 6 | 14 | | |
| | 8 | | | |
| | 11 | | | |
| | 13 | | | |
| | 15 | | | |

Having selected a VLC codeword to represent a particular (*run, level*) pair, using the mapping procedure described above, video multiplex coder 670 transmits the codeword to the decoder in the bit-stream 635. If there are more (*run, level*) pairs to be encoded for the current block, it then updates *max_run* for use in connection with encoding the next (*run, level*) pair by subtracting the current *run* value, i.e.:

$$max_run = max_run - run$$

The coding procedure continues until all (*run, level*) pairs for a given block have been represented as codewords, whereupon video multiplex coder 670 receives the next block of quantised transform coefficients for coding and repeats the coding process for the next block.

Operation of a video decoder 700 according to the invention will now be described with reference to Figure 6. The structure of the video decoder illustrated in Figure 6 is substantially identical to that of the prior art video decoder shown in Figure 2, with appropriate modifications to those parts of the decoder that perform variable length decoding operations. All parts of the video decoder that implement functions and operate in a manner identical to the previously described prior art video decoder are identified with identical reference numbers. In the description that follows it is assumed that all variable length decoding operations are performed in video multiplex decoder 770. However, it should be appreciated that in alternative embodiments of the invention a separate variable length decoding unit or units may be provided.

Operation of the video decoder will now be described in detail. Here it is assumed that the video decoder of Figure 6 corresponds to the encoder described in connection with Figure 5 and is therefore capable of receiving and decoding the bit-stream 635 transmitted by encoder 600. In the decoder, the bit-stream is received and separated into its constituent parts by video multiplex decoder 770. As explained in connection with the earlier description of prior art, the compressed video data extracted from the bit-stream is processed on a macroblock-by-macroblock basis. According to the invention, the compressed video data for an INTRA-coded macroblock comprises variable length codewords representing VLC coded (*run, level*) pairs for each block of the macroblock, together with an indication of the number $N_c$ of non-zero-valued quantised transform coefficients present in each block, and encoded control information (for example, relating to quantisation parameter QP). The compressed video data for an INTER-coded macroblock comprises VLC encoded prediction error information for each block (comprising VLC coded (*run, level*) pairs and an indication of $N_c$ for each block), motion vector information for the macroblock and encoded control information.

The $N_c$ value and VLC coded (*run, level*) pairs for each block of an INTRA-coded macroblock and for each block of prediction error data associated with an INTER-coded macroblock are handled in an identical fashion.

More specifically, when decoding the VLC coded (*run, level*) pairs for an INTRA- or INTER-coded image block, video multiplex decoder 770 first determines the number of non-zero-valued quantised transform coefficients in the block. As previously explained, information relating to the number of non-zero-valued quantised transform coefficients, $N_c$, is inserted into bit-stream 635 by encoder 600. The video multiplex decoder 770 of decoder 700 extracts this information from the received bit-stream.

Video multiplex decoder 770 then starts to decode the VLC encoded (*run, length*) pairs for the image block. According to the invention, the decoding operation is performed in a manner analogous to the encoding procedure performed in the encoder and described above. More specifically, when decoding the first variable length codeword associated with a particular image block, video multiplex decoder 770 initialises the value of *max_run* by setting it equal to the maximum number of non-zero-valued coefficients that can be present in a block minus the value of $N_c$ relating to the block in question that was extracted from the received bit-stream. It then determines the code number corresponding to the received codeword and, dependent on the value of *max_run,* selects a mapping table relating the code number to a particular combination of *run* and *level* values, the mapping tables used in the decoder corresponding to those used to generate the codewords in the encoder.

Having recovered the *level* and *run* values corresponding to the first non-zero-valued quantised transform coefficient of the block, video multiplex decoder 770 updates the value of *max_run* by subtracting the *run* value just determined and starts decoding the next codeword for the block. This process continues until all the codewords representative of the particular image block are decoded, whereupon video multiplex decoder 770 reconstructs the quantised transform coefficient values for the block from the decoded (*run, level*) pairs and passes them to inverse quantiser 210. The remainder of the video decoding procedure, whereby reconstructed pixel values are formed for each image block, proceeds as described in connection with prior art video decoder 200.

Figure 7 presents a terminal device comprising video encoding and decoding equipment which may be adapted to operate in accordance with the present invention. More precisely, the figure illustrates a multimedia terminal 80 implemented according to ITU-T recommendation H.324. The terminal can be regarded as a multimedia transceiver device. It includes elements that capture, encode and multiplex multimedia data streams for transmission via a communications network, as well as elements that receive, de-multiplex, decode and display received multimedia content. ITU-T recommendation H.324 defines the overall operation of the terminal and refers to other recommendations that govern the operation of its various constituent parts. This kind of multimedia terminal can be used in real-time applications such as conversational videotelephony, or non real-time applications such as the retrieval and / or streaming of video clips, for example from a multimedia content server in the Internet.

In the context of the present invention, it should be appreciated that the H.324 terminal shown in Figure 7 is only one of a number of alternative multimedia terminal implementations suited to application of the inventive method. It should also be noted that a number of alternatives exist relating to the location and implementation of the terminal equipment. As illustrated in Figure 7, the multimedia terminal may be located in communications equipment connected to a fixed line telephone network such as an analogue PSTN (Public Switched Telephone Network). In this case the multimedia terminal is equipped with a modem 91, compliant with ITU-T recommendations V.8, V.34 and optionally V. 8bis. Alternatively, the multimedia terminal may be connected to an external modem. The modem enables conversion of the multiplexed digital data and control signals produced by the multimedia terminal into an analogue form suitable for transmission over the PSTN. It further enables the multimedia terminal to receive data and control signals in analogue form from the PSTN and to convert them into a digital data stream that can be demultiplexed and processed in an appropriate manner by the terminal.

An H.324 multimedia terminal may also be implemented in such a way that it can be connected directly to a digital fixed line network, such as an ISDN (Integrated Services Digital Network). In this case the modem 91 is replaced with an ISDN user-network interface. In Figure 7, this ISDN user-network interface is represented by alternative block 92.

H.324 multimedia terminals may also be adapted for use in mobile communication applications. If used with a wireless communication link, the modem 91 can be replaced with any appropriate wireless interface, as represented by alternative block 93 in Figure 7. For example, an H.324/M multimedia terminal can include a radio transceiver enabling connection to the current 2$^{nd}$ generation GSM mobile telephone network, or the proposed 3$^{rd}$ generation UMTS (Universal Mobile Telephone System).

It should be noted that in multimedia terminals designed for two-way communication, that is for transmission and reception of video data, it is advantageous to provide both a video encoder and video decoder implemented according to the present invention. Such an encoder and decoder pair is often implemented as a single combined functional unit, referred to as a "codec".

A typical H.324 multimedia terminal will now be described in further detail with reference to Figure 7.

The multimedia terminal 80 includes a variety of elements referred to as "terminal equipment". This includes video, audio and telematic devices, denoted generically by reference numbers 81, 82 and 83, respectively. The video equipment 81 may include, for example, a video camera for capturing video images, a monitor for displaying received video content and optional video processing equipment. The audio equipment 82 typically includes a microphone, for example for capturing spoken messages, and a loudspeaker for reproducing received audio content. The audio equipment may also include additional audio processing units. The telematic equipment 83, may include a data terminal, keyboard, electronic whiteboard or a still image transceiver, such as a fax unit.

The video equipment 81 is coupled to a video codec 85. The video codec 85 comprises a video encoder and a corresponding video decoder both implemented according to the invention. Such an encoder and a decoder will be described in the following. The video codec 85 is responsible for encoding captured video data in an appropriate form for further transmission over a communications link and decoding compressed video content received from the communications network. In the example illustrated in Figure 7, the video codec is implemented according to ITU-T recommendation H.26L, with appropriate modifications to implement the adaptive variable length coding method according to the invention in both the encoder and the decoder of the video codec.

The terminal's audio equipment is coupled to an audio codec, denoted in Figure 7 by reference number 86. Like the video codec, the audio codec comprises an encoder/decoder pair. It converts audio data captured by the terminal's audio equipment into a form suitable for transmission over the communications link and transforms encoded audio data received from the network back into a form suitable for reproduction, for example on the terminal's loudspeaker. The output of the audio codec is passed to a delay block 87. This compensates for the delays introduced by the video coding process and thus ensures synchronisation of audio and video content.

The system control block 84 of the multimedia terminal controls end-to-network signalling using an appropriate control protocol (signalling block 88) to establish a common mode of operation between a transmitting and a receiving terminal. The signalling block 88 exchanges information about the encoding and decoding capabilities of the transmitting and receiving terminals and can be used to enable the various coding modes of the video encoder. The system control block 84 also controls the use of data encryption. Information regarding the type of encryption to be used in data transmission is passed from encryption block 89 to the multiplexer/demultiplexer (MUX/DMUX unit) 90.

During data transmission from the multimedia terminal, the MUX/DMUX unit 90 combines encoded and synchronised video and audio streams with data input from the telematic equipment 83 and possible control data, to form a single bit-stream. Information concerning the type of data encryption (if any) to be applied to the bit-stream, provided by encryption block 89, is used to select an encryption mode. Correspondingly, when a multiplexed and possibly encrypted multimedia bit-stream is being received, MUX/DMUX unit 90 is responsible for decrypting the bit-stream, dividing it into its constituent multimedia components and passing those components to the appropriate codec(s) and/or terminal equipment for decoding and reproduction.

It should be noted that the functional elements of the multimedia terminal, video encoder, decoder and video codec according to the invention can be implemented as software or dedicated hardware, or a combination of the two. The variable length coding and decoding methods according to the invention are particularly suited for implementation in the form of a computer program comprising machine-readable instructions for performing the functional steps of the invention. As such, the variable length encoder and decoder according to the invention may be implemented as software code stored on a storage medium and executed in a computer, such as a personal desktop computer.

If the multimedia terminal 80 is a mobile terminal, that is, if it is equipped with a radio transceiver 93, it will be understood by those skilled in the art that it may also comprise additional elements. In one embodiment it comprises a user interface having a display and a keyboard, which enables operation of the multimedia terminal 80 by a user, a central processing unit, such as a microprocessor, which controls the blocks responsible for different functions of the multimedia terminal, a random access memory RAM, a read only memory ROM, and a digital camera. The microprocessor's operating instructions, that is program code corresponding to the basic functions of the multimedia terminal 80, is stored in the read-only memory ROM and can be executed as required by the microprocessor, for example under control of the user. In accordance with the program code, the microprocessor uses the radio transceiver 93 to form a connection with a mobile communication network, enabling the multimedia terminal 80 to transmit information to and receive information from the mobile communication network over a radio path.

The microprocessor monitors the state of the user interface and controls the digital camera. In response to a user command, the microprocessor instructs the camera to record digital images into the RAM. Once an image is captured, or alternatively during the capturing process, the microprocessor segments the image into image segments (for example macroblocks) and uses the encoder to perform motion compensated encoding of the segments in order to generate a compressed image sequence, as explained in the foregoing description. A user may command the multimedia terminal 80 to display the captured images on its display or to send the compressed image sequence using the radio transceiver 93 to another multimedia terminal, a video telephone connected to a fixed line network (PSTN) or some other telecommunications device. In a preferred embodiment, transmission of image data is started as soon as the first segment is encoded so that the recipient can start a corresponding decoding process with a minimum delay.

Although described in the context of particular embodiments, it will be apparent to those skilled in the art that a number of modifications and various changes to these teachings may occur. Thus, while the invention has been particularly shown and described with respect to one or more preferred embodiments thereof, it will be understood by those skilled in the art that certain modifications or changes may be made.

An alternative embodiment of the invention is based on the observation that the zigzag scanning of coefficients tends to order the coefficients according to their values, such that coefficients positioned earlier in the one-dimensional array are more likely to have larger absolute values than coefficients positioned later in the array. Therefore, consecutive *level* values exhibit significant similarity, i.e., within a given block of transform coefficients, the *level* of a coefficient to be encoded has, in general, a magnitude substantially similar to the *level* of the previously encoded coefficient. This alternative embodiment exploits this similarity by encoding (*run, level*) pairs according to the following relationship:

$$\text{Index_RL} = \text{RL_index}[\mathit{max_run}, \mathit{level}, \mathit{run}, \mathit{prev_level}] \quad (3)$$

Where *prev_level* is the previously coded *level* value in the block. Compared with the previously described embodiments, there is an additional parameter (namely *prev_level* that affects the assignment of index values to (*run, level*) pairs.

A further embodiment of the invention finds its basis in the fact that consecutive *level* values exhibit strong correlation. More specifically, previously coded *level* values may be used to assign a different VLC codebook to encode the current symbol in addition to being used in index assignment. The following exemplary pseudo-code provides one procedure for assigning a VLC codebook to (*run, level*) pair code number found by employing one of the previously described embodiments of the invention:

$$\text{VLC_N} = \text{Nc_map}[\mathit{prev_level}] \quad (4)$$

Where *prev_level* is the previously coded *level* value in the block and Nc_map is an array that maps integer values to different available VLC codes.

## Claims

1. A method of variable-length encoding a set of data symbols comprising zero-valued data symbols and non-zero-valued data symbols, the method **characterised by**:

    - representing a non-zero-valued data symbol of the set of data symbols by a data symbol pair representative of the non-zero-valued data symbol and an associated number of preceding or following zero-valued data symbols;
    - selecting a variable length codebook from a set of codebooks based on the value of a previously encoded non-zero-valued data symbol;
    - assigning a codeword from the selected variable length codebook to represent the data symbol pair by performing a mapping operation, wherein the mapping operation by which said codeword is assigned is adapted dependent on a maximum possible number of zero-valued data symbols in said set of data symbols;
    - updating the maximum possible number of zero-valued data symbols in said set of data symbols in connection with assigning a data symbol pair to a codeword by subtracting said associated number of preceding or following zero-valued data symbols from said maximum possible number of zero-valued data symbols to yield an updated maximum possible number of zero-valued data symbols, wherein the mapping operation by which a subsequent codeword is assigned to a data symbol pair is adapted dependent on said updated maximum possible number of zero-valued data symbols;
    - providing a codeword representative of the number of non-zero-valued data symbols in said set of data symbols in an encoded bitstream.

2. An encoding method according to claim 1, **characterised by** continuing the encoding until all data symbol pairs of said set of data symbols have been assigned a codeword.

3. An encoding method according to claim 1 or 2, **characterised in that** the maximum possible number of number of zero-valued data symbols in said set of data symbols is determined by subtracting the number of non-zero-valued data symbols in said set of data symbols from the total number of data symbols in said set.

4. An encoding method according to claim 1, 2 or 3, **characterised in that** an indication of the number of non-zero-valued data symbols in said set of data symbols is transmitted to a corresponding decoding device.

5. An encoding method according to any of claims 1 to 4, **characterised in that** said mapping operation is performed by selecting a particular mapping table from a set of mapping tables in dependence at least in part on said maximum possible number of zero-valued data symbols in said set of data symbols, each mapping table of said set defining an assignment of data symbols to codewords.

6. An encoding method according to claim 5, **characterised in that** each of said mapping tables defines an assignment of data symbol pairs to codewords.

7. An encoding method according to claim 5, **characterised in that** each of said mapping tables defines an assignment of data symbol pairs to codenumbers, each codenumber being representative of a codeword in a set of codewords, and being used as a reference into the set of codewords, thereby defining an assignment of data symbol pairs to codewords.

8. An encoding method according to any of claims 1 to 7, **characterised in that** said set of data symbols is representative of transform coefficient values.

9. An encoding method according to any of claims 1 to 9, used in a video encoder.

10. A method of variable-length decoding a set of codewords representative of a set of data symbols, said set of data symbols comprising zero-valued data symbols and non-zero-valued data symbols, **characterised by**

    - receiving a codeword representative of number of non-zero-valued data symbols in said set of data symbols in an encoded bitstream;
- selecting a variable length codebook from a set of codebooks based on the value of a previously encoded non-zero-valued data symbol;
- receiving a codeword representative of a data symbol pair, the data symbol pair representing a non-zero-valued data symbol and an associated number of preceding or following zero-valued data symbols;
- decoding said codeword by using the selected variable length codebook to recover said data symbol pair by performing an inverse mapping operation, wherein the inverse mapping operation by which the data symbol pair is decoded is dependent on a maximum possible number of zero-valued data symbols in said set of data symbols;
- updating the maximum possible number of zero-valued data symbols in said set of data symbols in connection with decoding a received codeword to recover a data symbol pair represented by said codeword by subtracting said associated number of preceding or following zero-valued data symbols from said maximum possible number of zero-valued data symbols to yield an updated maximum possible number of zero-valued data symbols, wherein the inverse mapping operation by which a subsequent codeword is decoded to recover a data symbol pair represented by said subsequent codeword is adapted dependent on said updated maximum possible number of zero-valued data symbols.

**11.** A decoding method according to claim 10, the method **characterised by** receiving an indication of the number of non-zero data symbols in said set of data symbols.

**12.** A decoding method according to claim 10 or 11, **characterised in that** the maximum possible number of zero-valued data symbols in said set of data symbols is determined by subtracting the number of non-zero-valued data symbols in said set of data symbols from the total number of data symbols in said set.

**13.** A decoding method according to claim 11 or 12, **characterised in that** the indication of the number of non-zero-valued data symbols in said set of data symbols is received from a corresponding encoding device.

**14.** A decoding method according to any of claims 10 to 13, **characterised in that** said inverse mapping operation is performed by selecting a particular inverse mapping table from a set of inverse mapping tables in dependence on said maximum possible number of zero-valued data symbols in said set of data symbols, each inverse mapping table of said set defining an assignment of codewords to data symbols.

**15.** A decoding method according to claim 14, **characterised in that** each of said inverse mapping tables defines an assignment of codewords to data symbol pairs.

**16.** A decoding method according to claim 14, **characterised in that** said received codeword is decoded to recover a codenumber, said codenumber being used as a reference into the particular inverse mapping table selected at least in part in dependence on said maximum possible number of zero-valued data symbols in said set of data symbols, thereby recovering the data symbol pairrepresented by said codeword.

**17.** A decoding method according to any of claims 10 to 16, **characterised in that** said set of data symbols is representative of transform coefficient values.

**18.** A decoding method according to any of claims 10 to 17, used in a video decoder.

**19.** A variable-length encoder for encoding a set of data symbols comprising zero-valued data symbols and non-zero-valued data symbols, **characterised in that** the encoder is adapted to represent a non-zero-valued data symbol of the set of data symbols by a data symbol pair representative of the non-zero-valued data symbols and an associated number of preceding or following zero-valued data symbols, and that the encoder comprises:

- means for selecting a variable length codebook from a set of codebooks based on the value of a previously encoded non-zero-valued data symbol,
- means for assigning a codeword from the selected variable length codebook to represent the data symbol pair by performing a mapping operation, wherein said means for assigning a codeword is arranged to adapt the mapping operation by which said codeword is assigned in dependence on a maximum possible number of zero-valued data symbols in said set of data symbols;
- means for updating the maximum possible number of zero-valued data symbols in said set of data symbols in connection with assigning a data symbol pair to a codeword by subtracting said associated number of preceding or following zero-valued data symbols from said maximum possible number of zero-valued data symbols to yield an updated maximum possible number of zero-valued data symbols, wherein said means for assigning a codeword to represent a data symbol pair is arranged to adapt the mapping operation by which a subsequent codeword is assigned to a data symbol pair in dependence on said updated maximum possible number of zero-valued data symbols; and
- means for providing a codeword representative of the number of non-zero-valued data symbols in said set of data symbols in an encoded bitstream.

**20.** A encoder according to claim 19, **characterised in that** it is arranged to continue the encoding until all data symbol pairs of said set of data symbols have been assigned a codeword.

**21.** An encoder according to claim 19 or 20, **characterised in that** it is arranged to determine the maximum possible number of zero-valued data symbols in said set of data symbols by subtracting the number of non-zero-valued data symbols in said set of data symbols from the total number of data symbols in said set.

**22.** An encoder according to claim 19, 20 or 21, **characterised in that** it is arranged to transmit an indication of the number of non-zero-valued data symbols in said set of data symbols to a corresponding decoding device.

**23.** An encoder according to any of claims 19 to 22, **characterised in that** said means for assigning a codeword to represent a data symbol pair is arranged to perform said mapping operation by selecting a particular mapping table from a set of mapping tables in dependence at least in part on said maximum possible number of zero-valued data symbols in said set of data symbols, each mapping table of said set defining an assignment of data symbols to codewords.

**24.** An encoder according to claim 23, **characterised in that** each of said mapping tables defines an assignment of data symbol pairs to codewords.

**25.** An encoder according to claim 23, **characterised in that** each of said mapping tables defines an assignment of data symbol pairs of to codenumbers, each codenumber being representative of a codeword to represent a data symbol pair in a set of codewords, wherein said means for assigning a codeword is arranged to use said codenumbers as references into the set of codewords, thereby defining an assignment of data symbol pairs to codewords.

**26.** An encoder according to any of claims 19 to 25, **characterised in that** said set of data symbols is representative of transform coefficient values.

**27.** A video encoder comprising an encoder according to any of claims 19 to 26.

**28.** A variable-length decoder for decoding a set of codewords representative of a set of data symbols, said set of data symbols comprising zero-valued data symbols and non-zero-valued data symbols,
**characterised in that** the decoder further comprises:

- means for receiving a codeword representative of the number of non-zero-valued data symbols in said set of data symbols in an encoded bitstream;
- means for selecting a variable length codebook from a set of codebooks based on the value of a previously encoded non-zero-valued data symbol;
- means for receiving a codeword representative of a data symbol pair, the data symbol pair representing a non-zero-valued data symbol and an associated number of preceding or following zero-valued data symbols;
- means for decoding said received codeword by using the selected variable length codebook to recover said data symbol pair by performing an inverse mapping operation, wherein said means for decoding said codeword is arranged to adapt the inverse mapping operation by which the data symbol pair is decoded in dependence on a maximum possible number of zero-valued data symbols in said set of data symbols;
- means for updating the maximum possible number of zero-valued data symbols in said set of data symbols in connection with decoding a received codeword to recover a data symbol pair represented by said codeword by subtracting said associated number of preceding or following zero-valued data symbols from said maximum possible number of zero-valued data symbols to yield an updated maximum possible number of zero-valued data symbols, wherein said means for decoding a codeword is arranged to adapt the inverse mapping operation by which a subsequent codeword is decoded to recover a data symbol pair represented by said subsequent codeword in dependence on said updated maximum possible number of zero-valued data symbols.

**29.** A decoder according to claim 28, **characterised in that** it is arranged to receive an indication of a number of non-zero-valued data symbols in said set of data symbols.

**30.** A decoder according to claim 28 or 29, **characterised in that** it is arranged to determine the maximum possible number of zero-valued data symbols in said set of data symbols by subtracting the number of non-zero-valued data symbols in said set of data symbols from the total number of data symbols in said set.

**31.** A decoder according to claim 29 or 30, **characterised in that** it is arranged to receive said indication of the number of non-zero-valued data symbols in said set of data symbols from a corresponding encoding device.

**32.** A decoder according to any of claims 28 to 31, **characterised in that** said means for decoding a codeword is arranged to perform said inverse mapping operation by selecting a particular inverse mapping table from a set of inverse mapping tables in dependence at least in part on said maximum possible number of zero-valued data symbols in said set of data symbols, each inverse mapping table of said set defining an assignment of codewords to data symbols.

**33.** A decoder according to claim 32, **characterised in that** each of said inverse mapping tables defines an assignment of codewords to data symbol pairs.

**34.** A decoder according to claim 32, **characterised in that** said means for decoding a codeword is arranged to decode a received codeword to recover a codenumber, and to use said codenumber as a reference into the particular inverse mapping table selected in dependence at least in part on said maximum possible number of zero-valued data symbols in said set of data symbols, thereby recovering a data symbol pair.

**35.** A decoder according to any of claim 28 to 34, **characterised in that** said set of data symbols is representative of transform coefficient values.

**36.** A video decoder comprising a decoder according to any of claims 28 to 35.

**37.** A multimedia terminal comprising a video encoder according to claim 27.

**38.** A multimedia terminal comprising a video decoder according to claim 36.

**39.** A multimedia terminal according to claim 37 or 38, **characterised in that** it comprises means for forming a wireless link to a radio communications network.

## Patentansprüche

**1.** Verfahren zum Variable-Length-Coding eines Satzes von Datensymbolen, umfassend Datensymbole mit Nullwert und Datensymbole mit Nichtnullwert, wobei das Verfahren **gekennzeichnet ist durch**:

- Repräsentieren eines Datensymbols mit Nichtnullwert des Satzes von Datensymbolen **durch** ein Datensymbolpaar, welches repräsentativ ist für das Datensymbol mit Nichtnullwert und eine zugeordnete Anzahl vorausgehender oder folgender Datensymbole mit Nullwert;
- Auswählen eines Variable-Length-Coding-Codebuchs aus einem Satz von Codebüchern, basierend auf dem Wert eines zuvor codierten Datensymbols mit Nichtnullwert;
- Zuweisen eines Codeworts aus dem ausgewählten Variable-Length-Coding-Codebuch, um das Datensymbolpaar **durch** Ausführen einer Mapping-Operation zu repräsentieren, wobei die Mapping-Operation, **durch** welche das Codewort zugewiesen wird, angepasst wird, abhängig von einer maximal möglichen Anzahl an Datensymbolen mit Nullwert in dem Satz von Datensymbolen;
- Aktualisieren der maximal möglichen Anzahl an Datensymbolen mit Nullwert in dem Satz von Datensymbolen in Verbindung mit Zuweisen eines Datensymbolpaares zu einem Codewort **durch** Subtrahieren der zugeordneten Anzahl vorausgehender oder folgender Datensymbole mit Nullwert von der maximal möglichen Anzahl an Datensymbolen mit Nullwert, um eine aktualisierte maximal mögliche Anzahl an Datensymbolen mit Nullwert zu erhalten, wobei die Mapping-Operation, **durch** welche ein nachfolgendes Codewort einem Datensymbolpaar zugewiesen wird, angepasst wird, abhängig von der aktualisierten maximal möglichen Anzahl an Datensymbolen mit Nullwert;

- Bereitstellen eines Codeworts, welches für die Anzahl an Datensymbolen mit Nichtnullwert in dem Satz von Datensymbolen repräsentativ ist, in einem codierten Bitstrom.

**2.** Codierverfahren nach Anspruch 1, **gekennzeichnet durch** Fortsetzen des Codierens, bis allen Datensymbolpaaren des Satzes von Datensymbolen ein Codewort zugewiesen worden ist.

**3.** Codierverfahren nach Anspruch 1 oder 2, **dadurch gekennzeichnet, dass** die maximal mögliche Anzahl an Datensymbolen mit Nullwert in dem Satz von Datensymbolen durch Subtrahieren der Anzahl an Datensymbolen mit Nichtnullwert in dem Satz von Datensymbolen von der Gesamtanzahl an Datensymbolen in dem Satz bestimmt wird.

**4.** Codierverfahren nach Anspruch 1, 2 oder 3, **dadurch gekennzeichnet, dass** eine Angabe der Anzahl an Datensymbolen mit Nichtnullwert in dem Satz von Datensymbolen an ein entsprechendes Decodiergerät gesendet wird.

**5.** Codierverfahren nach einem der Ansprüche 1 bis 4, **dadurch gekennzeichnet, dass** die Mapping-Operation durch Auswählen einer konkreten Mapping-Tabelle aus einem Satz von Mapping-Tabellen ausgeführt wird, wenigstens teilweise in Abhängigkeit von der maximal möglichen Anzahl an Datensymbolen mit Nullwert in dem Satz von Datensymbolen, wobei jede Mapping-Tabelle des Satzes eine Zuweisung von Datensymbolen zu Codewörtern definiert.

**6.** Codierverfahren nach Anspruch 5, **dadurch gekennzeichnet, dass** jede der Mapping-Tabellen eine Zuweisung von Datensymbolpaaren zu Codewörtern definiert.

**7.** Codierverfahren nach Anspruch 5, **dadurch gekennzeichnet, dass** jede der Mapping-Tabellen eine Zuweisung von Datensymbolpaaren zu Codenummern definiert, wobei jede Codenummer für ein Codewort in einem Satz von Codewörtern repräsentativ ist und als ein Verweis in den Satz von Codewörtern verwendet wird, wobei eine Zuweisung von Datensymbolpaaren zu Codewörtern definiert wird.

**8.** Codierverfahren nach einem der Ansprüche 1 bis 7, **dadurch gekennzeichnet, dass** der Satz von Datensymbolen für Transformationskoeffizienten-Werte repräsentativ ist.

**9.** Codierverfahren nach einem der Ansprüche 1 bis 8, welches in einem Videocodierer verwendet wird.

**10.** Verfahren zum Variable-Length-Coding-Decodieren eines Satzes von Codewörtern, welche für einen Satz von Datensymbolen repräsentativ sind, wobei der Satz von Datensymbolen Datensymbole mit Nullwert und Datensymbole mit Nichtnullwert umfasst, **gekennzeichnet durch**:

- Empfangen eines Codeworts, welches für eine Anzahl an Datensymbolen mit Nichtnullwert in dem Satz von Datensymbolen repräsentativ ist, in einem codierten Bitstrom;
- Auswählen eines Variable-Length-Coding-Codebuchs aus einem Satz von Codebüchern, basierend auf dem Wert eines zuvor codierten Datensymbols mit Nichtnullwert;
- Empfangen eines Codeworts, welches für ein Datensymbolpaar repräsentativ ist, wobei das Datensymbolpaar ein Datensymbol mit Nichtnullwert und eine zugeordnete Anzahl vorausgehender oder folgender Datensymbole mit Nullwert repräsentiert;
- Decodieren des Codeworts **durch** Verwenden des ausgewählten Variable-Length-Coding-Codebuchs, um das Datensymbolpaar wiederherzustellen, **durch** Ausführen einer inversen Mapping-Operation, wobei die inverse Mapping-Operation, **durch** welche das Datensymbolpaar decodiert wird, abhängig ist von einer maximal möglichen Anzahl an Datensymbolen mit Nullwert in dem Satz von Datensymbolen;
- Aktualisieren der maximal möglichen Anzahl an Datensymbolen mit Nullwert in dem Satz von Datensymbolen in Verbindung mit Decodieren eines empfangenen Codeworts, um ein Datensymbolpaar wiederherzustellen, welches **durch** das Codewort repräsentiert ist, **durch** Subtrahieren der zugeordneten Anzahl vorausgehender oder folgender Datensymbole mit Nullwert von der maximal möglichen Anzahl an Datensymbolen mit Nullwert, um eine aktualisierte maximal mögliche Anzahl an Datensymbolen mit Nullwert zu erhalten, wobei die inverse Mapping-Operation, **durch** welche ein nachfolgendes Codewort decodiert wird, um ein Datensymbolpaar wiederherzustellen, welches von dem nachfolgenden Codewort repräsentiert ist, angepasst wird, abhängig von der aktualisierten maximal möglichen Anzahl an Datensymbolen mit Nullwert.

**11.** Decodierverfahren nach Anspruch 10, wobei das Verfahren **gekennzeichnet ist durch** Empfangen einer Angabe der Anzahl an Datensymbolen mit Nichtnullwert in dem Satz von Datensymbolen.

**12.** Decodierverfahren nach Anspruch 10 oder 11, **dadurch gekennzeichnet, dass** die maximal mögliche Anzahl an Datensymbolen mit Nullwert in dem Satz von Datensymbolen durch Subtrahieren der Anzahl an Datensymbolen mit Nichtnullwert in dem Satz von Datensymbolen von der Gesamtanzahl an Datensymbolen in dem Satz bestimmt wird.

**13.** Decodierverfahren nach Anspruch 11 oder 12, **dadurch gekennzeichnet, dass** die Angabe der Anzahl an Datensymbolen mit Nichtnullwert in dem Satz von Datensymbolen von einem entsprechenden Codiergerät aus empfangen wird.

**14.** Decodierverfahren nach einem der Ansprüche 10 bis 13, **dadurch gekennzeichnet, dass** die inverse Mapping-Operation durch Auswählen einer konkreten inversen Mapping-Tabelle aus einem Satz inverser Mapping-Tabellen ausgeführt wird, in Abhängigkeit von der maximal möglichen Anzahl an Datensymbolen mit Nullwert in dem Satz von Datensymbolen, wobei jede inverse Mapping-Tabelle des Satzes eine Zuweisung von Codewörtern zu Datensymbolen definiert.

**15.** Decodierverfahren nach Anspruch 14, **dadurch gekennzeichnet, dass** jede der inversen Mapping-Tabellen eine Zuweisung von Codewörtern zu Datensymbolpaaren definiert.

**16.** Decodierverfahren nach Anspruch 14, **dadurch gekennzeichnet, dass** das empfangene Codewort decodiert wird, um eine Codenummer wiederherzustellen, wobei die Codenummer als ein Verweis in die konkrete inverse Mapping-Tabelle verwendet wird, welche wenigstens teilweise in Abhängigkeit von der maximal möglichen Anzahl an Datensymbolen mit Nullwert in dem Satz von Datensymbolen ausgewählt ist, wobei das Datensymbolpaar, welches durch das Codewort repräsentiert ist, wiederhergestellt wird.

**17.** Decodierverfahren nach einem der Ansprüche 10 bis 16, **dadurch gekennzeichnet, dass** der Satz von Datensymbolen für Transformationskoeffizienten-Werte repräsentativ ist.

**18.** Decodierverfahren nach einem der Ansprüche 10 bis 17, welches in einem Videodecodierer verwendet wird.

**19.** Variable-Length-Coding-Codierer zum Codieren eines Satzes von Datensymbolen, umfassend Datensymbole mit Nullwert und Datensymbole mit Nichtnullwert, **dadurch gekennzeichnet, dass** der Codierer angepasst ist, ein Datensymbol mit Nichtnullwert des Satzes von Datensymbolen durch ein Datensymbolpaar zu repräsentieren, welches repräsentativ ist für die Datensymbole mit Nichtnullwert und eine zugeordnete Anzahl vorausgehender oder folgender Datensymbole mit Nullwert, und dass der Codierer umfasst:

- Mittel zum Auswählen eines Variable-Length-Coding-Codebuchs aus einem Satz von Codebüchern, basierend auf dem Wert eines zuvor codierten Datensymbols mit Nichtnullwert;
- Mittel zum Zuweisen eines Codeworts aus dem ausgewählten Variable-Length-Coding-Codebuch, um das Datensymbolpaar durch Ausführen einer Mapping-Operation zu repräsentieren, wobei das Mittel zum Zuweisen eines Codeworts angeordnet ist, die Mapping-Operation, durch welche das Codewort zugewiesen wird, in Abhängigkeit von einer maximal möglichen Anzahl an Datensymbolen mit Nullwert in dem Satz von Datensymbolen anzupassen;
- Mittel zum Aktualisieren der maximal möglichen Anzahl an Datensymbolen mit Nullwert in dem Satz von Datensymbolen in Verbindung mit Zuweisen eines Datensymbolpaares zu einem Codewort durch Subtrahieren der zugeordneten Anzahl vorausgehender oder folgender Datensymbole mit Nullwert von der maximal möglichen Anzahl an Datensymbolen mit Nullwert, um eine aktualisierte maximal mögliche Anzahl an Datensymbolen mit Nullwert zu erhalten, wobei das Mittel zum Zuweisen eines Codeworts, um ein Datensymbolpaar zu repräsentieren, angeordnet ist, die Mapping-Operation, durch welche ein nachfolgendes Codewort einem Datensymbolpaar zugewiesen wird, anzupassen, in Abhängigkeit von der aktualisierten maximal möglichen Anzahl an Datensymbolen mit Nullwert; und
- Mittel zum Bereitstellen eines Codeworts, welches für die Anzahl an Datensymbolen mit Nichtnullwert in dem Satz von Datensymbolen repräsentativ ist, in einem codierten Bitstrom.

**20.** Codierer nach Anspruch 19, **dadurch gekennzeichnet, dass** er angeordnet ist, das Codieren fortzusetzen, bis allen Datensymbolpaaren des Satzes von Datensymbolen ein Codewort zugewiesen worden ist.

**21.** Codierer nach Anspruch 19 oder 20, **dadurch gekennzeichnet, dass** er angeordnet ist, die maximal mögliche Anzahl an Datensymbolen mit Nullwert in dem Satz von Datensymbolen durch Subtrahieren der Anzahl an Datensymbolen mit Nichtnullwert in dem Satz von Datensymbolen von der Gesamtanzahl an Datensymbolen in dem Satz zu bestimmen.

**22.** Codierer nach Anspruch 19, 20 oder 21, **dadurch gekennzeichnet, dass** er angeordnet ist, eine Angabe der Anzahl an Datensymbolen mit Nichtnullwert in dem Satz von Datensymbolen an ein entsprechendes Decodiergerät zu senden.

**23.** Codierer nach einem der Ansprüche 19 bis 22, **dadurch gekennzeichnet, dass** das Mittel zum Zuweisen eines Codeworts, um ein Datensymbolpaar zu repräsentieren, angeordnet ist, die Mapping-Operation durch Auswählen einer konkreten Mapping-Tabelle aus einem Satz von Mapping-Tabellen auszuführen, wenigstens teilweise in Abhängigkeit von der maximal möglichen Anzahl an Datensymbolen mit Nullwert in dem Satz von Datensymbolen, wobei jede Mapping-Tabelle des Satzes eine Zuweisung von Datensymbolen zu Codewörtern definiert.

**24.** Codierer nach Anspruch 23, **dadurch gekennzeichnet, dass** jede der Mapping-Tabellen eine Zuweisung von Datensymbolpaaren zu Codewörtern definiert.

**25.** Codierer nach Anspruch 23, **dadurch gekennzeichnet, dass** jede der Mapping-Tabellen eine Zuweisung von Datensymbolpaaren zu Codenummern definiert, wobei jede Codenummer für ein Codewort repräsentativ ist, um ein Datensymbolpaar in einem Satz von Codewörtern zu repräsentieren, wobei das Mittel zum Zuweisen eines Codeworts angeordnet ist, die Codenummern als Verweise in den Satz von Codewörtern zu verwenden, wobei eine Zuweisung von Datensymbolpaaren zu Codewörtern definiert wird.

**26.** Codierer nach einem der Ansprüche 19 bis 25, **dadurch gekennzeichnet, dass** der Satz von Datensymbolen für Transformationskoeffizienten-Werte repräsentativ ist.

**27.** Videocodierer umfassend einen Codierer nach einem der Ansprüche 19 bis 26.

**28.** Variable-Length-Coding-Decodierer zum Decodieren eines Satzes von Codewörtern, welche für einen Satz von Datensymbolen repräsentativ sind, wobei der Satz von Datensymbolen Datensymbole mit Nullwert und Datensymbole mit Nichtnullwert umfasst, **dadurch gekennzeichnet, dass** der Decodierer ferner umfasst:

- Mittel zum Empfangen eines Codeworts, welches für die Anzahl an Datensymbolen mit Nichtnullwert in dem Satz von Datensymbolen repräsentativ ist, in einem codierten Bitstrom;
- Mittel zum Auswählen eines Variable-Length-Coding-Codebuchs aus einem Satz von Codebüchern, basierend auf dem Wert eines zuvor codierten Datensymbols mit Nichtnullwert;
- Mittel zum Empfangen eines Codeworts, welches für ein Datensymbolpaar repräsentativ ist, wobei das Datensymbolpaar ein Datensymbol mit Nichtnullwert und eine zugeordnete Anzahl vorausgehender oder folgender Datensymbole mit Nullwert repräsentiert;
- Mittel zum Decodieren des empfangenen Codeworts durch Verwenden des ausgewählten Variable-Length-Coding-Codebuchs, um das Datensymbolpaar wiederherzustellen, durch Ausführen einer inversen Mapping-Operation, wobei
das Mittel zum Decodieren des Codeworts angeordnet ist, die inverse Mapping-Operation, durch welche das Datensymbolpaar decodiert wird, anzupassen, in Abhängigkeit von einer maximal möglichen Anzahl an Datensymbolen mit Nullwert in dem Satz von Datensymbolen;
- Mittel zum Aktualisieren der maximal möglichen Anzahl an Datensymbolen mit Nullwert in dem Satz von Datensymbolen in Verbindung mit Decodieren eines empfangenen Codeworts, um ein Datensymbolpaar wiederherzustellen, welches durch das Codewort repräsentiert ist, durch Subtrahieren der zugeordneten Anzahl vorausgehender oder folgender Datensymbole mit Nullwert von der maximal möglichen Anzahl an Datensymbolen mit Nullwert, um eine aktualisierte maximal mögliche Anzahl an Datensymbolen mit Nullwert zu erhalten, wobei das Mittel zum Decodieren eines Codeworts angeordnet ist, die inverse Mapping-Operation, durch welche ein nachfolgendes Codewort decodiert wird, um ein Datensymbolpaar wiederherzustellen, welches von dem nachfolgenden Codewort repräsentiert ist, anzupassen, in Abhängigkeit von der aktualisierten maximal möglichen Anzahl an Datensymbolen mit Nullwert.

**29.** Decodierer nach Anspruch 28, **dadurch gekennzeichnet, dass** er angeordnet ist, eine Angabe einer Anzahl an Datensymbolen mit Nichtnullwert in dem Satz von Datensymbolen zu empfangen.

**30.** Decodierer nach Anspruch 28 oder 29, **dadurch gekennzeichnet, dass** er angeordnet ist, die maximal mögliche Anzahl an Datensymbolen mit Nullwert in dem Satz von Datensymbolen durch Subtrahieren der Anzahl an Datensymbolen mit Nichtnullwert in dem Satz von Datensymbolen von der Gesamtanzahl an Datensymbolen in dem Satz zu bestimmen.

**31.** Decodierer nach Anspruch 29 oder 30, **dadurch gekennzeichnet, dass** er angeordnet ist, die Angabe der Anzahl an Datensymbolen mit Nichtnullwert in dem Satz von Datensymbolen von einem entsprechenden Codiergerät aus zu empfangen.

**32.** Decodierer nach einem der Ansprüche 28 bis 31, **dadurch gekennzeichnet, dass** das Mittel zum Decodieren eines Codeworts angeordnet ist, die inverse Mapping-Operation durch Auswählen einer konkreten inversen Mapping-Tabelle aus einem Satz inverser Mapping-Tabellen auszuführen, wenigstens teilweise in Abhängigkeit von der maximal möglichen Anzahl an Datensymbolen mit Nullwert in dem Satz von Datensymbolen, wobei jede inverse Mapping-Tabelle des Satzes eine Zuweisung von Codewörtern zu Datensymbolen definiert.

**33.** Decodierer nach Anspruch 32, **dadurch gekennzeichnet, dass** jede der inversen Mapping-Tabellen eine Zuweisung von Codewörtern zu Datensymbolpaaren definiert.

**34.** Decodierer nach Anspruch 32, **dadurch gekennzeichnet, dass** das Mittel zum Decodieren eines Codeworts angeordnet ist, ein empfangenes Codewort zu decodieren, um eine Codenummer wiederherzustellen und die Codenummer als einen Verweis in die konkrete inverse Mapping-Tabelle zu verwenden, welche wenigstens teilweise in Abhängigkeit von der maximal möglichen Anzahl an Datensymbolen mit Nullwert in dem Satz von Datensymbolen ausgewählt ist, wobei ein Datensymbolpaar wiederhergestellt wird.

**35.** Decodierer nach einem der Ansprüche 28 bis 34, **dadurch gekennzeichnet, dass** der Satz von Datensymbolen für Transformationskoeffizienten-Werte repräsentativ ist.

**36.** Videodecodierer, umfassend einen Decodierer nach einem der Ansprüche 28 bis 35.

**37.** Multimediaterminal, umfassend einen Videocodierer nach Anspruch 27.

**38.** Multimediaterminal, umfassend einen Videodecodierer nach Anspruch 36.

**39.** Multimediaterminal nach Anspruch 37 oder 38, **dadurch gekennzeichnet, dass** es Mittel umfasst zum Herstellen einer Funkverbindung mit einem Funkkommunikationsnetz.

**Revendications**

**1.** Procédé d'encodage à longueur variable d'un jeu de symboles de données comprenant des symboles de données de valeur nulle et des symboles de données de valeur non nulle, le procédé étant **caractérisé par** les étapes consistant à :

- représenter un symbole de données de valeur non nulle du jeu de symboles de données par une paire de symboles de données représentative du symbole de données de valeur non nulle et un nombre associé de symboles de données de valeur nulle précédents ou suivants ;
- sélectionner un livre de codes à longueur variable à partir d'un jeu de livres de codes en se basant sur la valeur d'un symbole de données de valeur non nulle encodé antérieurement ;
- attribuer un mot de code à partir du livre de codes à longueur variable sélectionné pour représenter la paire de symboles de données en effectuant une opération de mise en correspondance, où l'opération de mise en correspondance par laquelle ledit mot de code est attribué est adaptée en fonction d'un nombre maximal possible de symboles de données de valeur nulle dans ledit jeu de symboles de données ;
- mettre à jour le nombre maximal possible de symboles de données de valeur nulle dans ledit jeu de symboles de données en relation avec l'attribution d'une paire de symboles de données à un mot de code en soustrayant ledit nombre associé de symboles de données de valeur nulle précédents ou suivants dudit nombre maximal possible de symboles de données de valeur nulle pour donner un nombre maximal possible mis à jour de symboles de données de valeur nulle, où l'opération de mise en correspondance par laquelle un mot de code ultérieur est attribué à une paire de symboles de données est adaptée en fonction dudit nombre maximal possible mis à jour de symboles de données de valeur nulle ;

- fournir un mot de code représentatif du nombre de symboles de données de valeur non nulle dans ledit jeu de symboles de données dans un train de bits encodé.

**2.** Procédé d'encodage selon la revendication 1, **caractérisé par** l'étape consistant à poursuivre l'encodage jusqu'à ce que toutes les paires de symboles de données dudit jeu de symboles de données se soient vues attribuer un mot de code.

**3.** Procédé d'encodage selon la revendication 1 ou 2, **caractérisé en ce que** le nombre maximal possible de symboles de données de valeur nulle dans ledit jeu de symboles de données est déterminé en soustrayant le nombre de symboles de données de valeur non nulle dans ledit jeu de symboles de données du nombre total de symboles de données dans ledit jeu.

**4.** Procédé d'encodage selon la revendication 1, 2 ou 3, **caractérisé en ce qu'**une indication du nombre de symboles de données de valeur non nulle dans ledit jeu de symboles de données est transmise à un dispositif de décodage correspondant.

**5.** Procédé d'encodage selon l'une quelconque des revendications 1 à 4, **caractérisé en ce que** ladite opération de mise en correspondance est effectuée en sélectionnant une table de mise en correspondance particulière à partir d'un jeu de tables de mise en correspondance en fonction au moins en partie dudit nombre maximal possible de symboles de données de valeur nulle dans ledit jeu de symboles de données, chaque table de mise en correspondance dudit jeu définissant une attribution de symboles de données à des mots de code.

**6.** Procédé d'encodage selon la revendication 5, **caractérisé en ce que** chacune desdites tables de mise en correspondance définit une attribution de paires de symboles de données à des mots de code.

**7.** Procédé d'encodage selon la revendication 5, **caractérisé en ce que** chacune desdites tables de mise en correspondance définit une attribution de paires de symboles de données à des numéros de code, chaque numéro de code étant représentatif d'un mot de code dans un jeu de mots de code et étant utilisé comme référence dans le jeu de mots de code définissant ainsi une attribution de paires de symboles de données à des mots de code.

**8.** Procédé d'encodage selon l'une quelconque des revendications 1 à 7, **caractérisé en ce que** ledit jeu de symboles de données est représentatif de valeurs de coefficient de transformée.

**9.** Procédé d'encodage selon l'une quelconque des revendications 1 à 9, utilisé dans un encodeur vidéo.

**10.** Procédé de décodage à longueur variable d'un jeu de mots de code représentatif d'un jeu de symboles de données, ledit jeu de symboles de données comprenant des symboles de données de valeur nulle et des symboles de données de valeur non nulle, **caractérisé par** les étapes consistant à :

- recevoir un mot de code représentatif d'un nombre de symboles de données de valeur non nulle dans ledit jeu de symboles de données dans un train de bits encodé ;
- sélectionner un livre de codes à longueur variable à partir d'un jeu de livres de codes en se basant sur la valeur d'un symbole de données de valeur non nulle encodé antérieurement ;
- recevoir un mot de code représentatif d'une paire de symboles de données, la paire de symboles de données représentant un symbole de données de valeur non nulle et un nombre associé de symboles de données de valeur nulle précédents ou suivants ;
- décoder ledit mot de code en utilisant le livre de codes à longueur variable sélectionné pour récupérer ladite paire de symboles de données en effectuant une opération de mise en correspondance inverse, où l'opération de mise en correspondance inverse par laquelle la paire de symboles de données est décodée dépend d'un nombre maximal possible de symboles de données de valeur nulle dans ledit jeu de symboles de données ;
- mettre à jour le nombre maximal possible de symboles de données de valeur nulle dans ledit jeu de symboles de données en relation avec le décodage d'un mot de code reçu pour récupérer une paire de symboles de données représentée par ledit mot de code en soustrayant ledit nombre associé de symboles de données de valeur nulle précédents ou suivants dudit nombre maximal possible de symboles de données de valeur nulle pour donner un nombre maximal possible mis à jour de symboles de données de valeur nulle, où l'opération de mise en correspondance inverse par laquelle un mot de code ultérieur est décodé pour récupérer une paire de symboles de données représentée par ledit mot de code ultérieur est adaptée en fonction dudit nombre maximal possible mis à jour de symboles de données de valeur nulle.

**11.** Procédé de décodage selon la revendication 10, **caractérisé par** l'étape consistant à recevoir une indication du nombre de symboles de données de valeur non nulle dans ledit jeu de symboles de données.

**12.** Procédé de décodage selon la revendication 10 ou 11, **caractérisé en ce que** le nombre maximal possible de symboles de données de valeur nulle dans ledit jeu de symboles de données est déterminé en soustrayant le nombre de symboles de données de valeur non nulle dans ledit jeu de symboles de données du nombre total de symboles de données dans ledit jeu.

**13.** Procédé de décodage selon la revendication 11 ou 12, **caractérisé en ce que** l'indication du nombre de symboles de données de valeur non nulle dans ledit jeu de symboles de données est reçue à partir d'un dispositif d'encodage correspondant.

**14.** Procédé de décodage selon l'une quelconque des revendications 10 à 13, **caractérisé en ce que** ladite opération de mise en correspondance inverse est effectuée en sélectionnant une table de mise en correspondance inverse particulière à partir d'un jeu de tables de mise en correspondance inverse en fonction dudit nombre maximal possible de symboles de données de valeur nulle dans ledit jeu de symboles de données, chaque table de mise en correspondance inverse dudit jeu définissant une attribution de mots de code à des symboles de données.

**15.** Procédé de décodage selon la revendication 14, **caractérisé en ce que** chacune desdites tables de mise en correspondance inverse définit une attribution de mots de code à des paires de symboles de données.

**16.** Procédé de décodage selon la revendication 14, **caractérisé en ce que** ledit mot de code reçu est décodé pour récupérer un numéro de code, ledit numéro de code étant utilisé comme référence dans la table de mise en correspondance inverse particulière sélectionnée au moins en partie en fonction dudit nombre maximal possible de symboles de données de valeur nulle dans ledit jeu de symboles de données, récupérant ainsi la paire de symboles de données représentée par ledit mot de code.

**17.** Procédé de décodage selon l'une quelconque des revendications 10 à 16, **caractérisé en ce que** ledit jeu de symboles de données est représentatif de valeurs de coefficient de transformée.

**18.** Procédé de décodage selon l'une quelconque des revendications 10 à 17, utilisé dans un décodeur vidéo.

**19.** Encodeur à longueur variable destiné à encoder un jeu de symboles de données comprenant des symboles de données de valeur nulle et des symboles de données de valeur non nulle, **caractérisé en ce que** l'encodeur est adapté pour représenter un symbole de données de valeur non nulle du jeu de symboles de données par une paire de symboles de données représentative des symboles de données de valeur non nulle et un nombre associé de symboles de données de valeur nulle précédents ou suivants, et **en ce que** l'encodeur comprend :

- un moyen pour sélectionner un livre de codes à longueur variable à partir d'un jeu de livres de codes en se basant sur la valeur d'un symbole de données de valeur non nulle antérieurement encodé,
- un moyen pour attribuer un mot de code à partir du livre de codes à longueur variable sélectionné pour représenter la paire de symboles de données en effectuant une opération de mise en correspondance, où ledit moyen pour attribuer un mot de code est agencé pour adapter l'opération de mise en correspondance par laquelle ledit mot de code est attribué en fonction d'un nombre maximal possible de symboles de données de valeur nulle dans ledit jeu de symboles de données ;
- un moyen pour mettre à jour le nombre maximal possible de symboles de données de valeur nulle dans ledit jeu de symboles de données en relation avec l'attribution d'une paire de symboles de données à un mot de code en soustrayant ledit nombre associé de symboles de données de valeur nulle précédents ou suivants dudit nombre maximal possible de symboles de données de valeur nulle pour donner un nombre maximal possible mis à jour de symboles de données de valeur nulle, où ledit moyen pour attribuer un mot de code pour représenter une paire de symboles de données est agencé pour adapter l'opération de mise en correspondance par laquelle un mot de code ultérieur est attribué à une paire de symboles de données en fonction dudit nombre maximal possible mis à jour de symboles de données de valeur nulle ; et
- un moyen pour fournir un mot de code représentatif du nombre de symboles de données de valeur non nulle dans ledit jeu de symboles de données dans un train de bits encodé.

**20.** Encodeur selon la revendication 19, **caractérisé en ce qu'**il est agencé pour poursuivre l'encodage jusqu'à ce que toutes les paires de symboles de données dudit jeu de symboles de données se soient vues attribuer un mot de code.

**21.** Encodeur selon la revendication 19 ou 20, **caractérisé en ce qu'**il est agencé pour déterminer le nombre maximal possible de symboles de données de valeur nulle dans ledit jeu de symboles de données en soustrayant le nombre de symboles de données de valeur non nulle dans ledit jeu de symboles de données du nombre total de symboles de données dans ledit jeu.

**22.** Encodeur selon la revendication 19, 20 ou 21, **caractérisé en ce qu'**il est agencé pour transmettre une indication du nombre de symboles de données de valeur non nulle dans ledit jeu de symboles de données à un dispositif de décodage correspondant.

**23.** Encodeur selon l'une quelconque des revendications 19 à 22, **caractérisé en ce que** ledit moyen pour attribuer un mot de code pour représenter une paire de symboles de données est agencé pour effectuer ladite opération de mise en correspondance en sélectionnant une table de mise en correspondance particulière à partir d'un jeu de tables de mise en correspondance en fonction au moins en partie dudit nombre maximal possible de symboles de données de valeur nulle dans ledit jeu de symboles de données, chaque table de mise en correspondance dudit jeu définissant une attribution de symboles de données à des mots de code.

**24.** Encodeur selon la revendication 23, **caractérisé en ce que** chacune desdites tables de mise en correspondance définit une attribution de paires de symboles de données à des mots de code.

**25.** Encodeur selon la revendication 23, **caractérisé en ce que** chacune desdites tables de mise en correspondance définit une attribution de paires de symboles de données à des numéros de code, chaque numéro de code étant représentatif d'un mot de code pour représenter une paire de symboles de données dans un jeu de mots de code, où ledit moyen pour attribuer un mot de code est agencé pour utiliser lesdits numéros de code comme références dans le jeu de mots de code, définissant ainsi une attribution de paires de symboles de données à des mots de code.

**26.** Encodeur selon l'une quelconque des revendications 19 à 25, **caractérisé en ce que** ledit jeu de symboles de données est représentatif de valeurs de coefficient de transformée.

**27.** Encodeur vidéo comprenant un encodeur selon l'une quelconque des revendications 19 à 26.

**28.** Décodeur à longueur variable destiné à décoder un jeu de mots de code représentatif d'un jeu de symboles de données, ledit jeu de symboles de données comprenant des symboles de données de valeur nulle et des symboles de données de valeur non nulle, **caractérisé en ce que** le décodeur comprend en outre :

- un moyen pour recevoir un mot de code représentatif du nombre de symboles de données de valeur non nulle dans ledit jeu de symboles de données dans un train de bits encodé ;
- un moyen pour sélectionner un livre de codes à longueur variable à partir d'un jeu de livres de codes en se basant sur la valeur d'un symbole de données de valeur non nulle antérieurement encodé ;
- un moyen pour recevoir un mot de code représentatif d'une paire de symboles de données, la paire de symboles de données représentant un symbole de données de valeur non nulle et un nombre associé de symboles de données de valeur nulle précédents ou suivants ;
- un moyen pour décoder ledit mot de code reçu en utilisant le livre de codes à longueur variable sélectionné pour récupérer ladite paire de symboles de données en effectuant une opération de mise en correspondance inverse, où
ledit moyen pour décoder ledit mot de code est agencé pour adapter l'opération de mise en correspondance inverse par laquelle la paire de symboles de données est décodée en fonction d'un nombre maximal possible de symboles de données de valeur nulle dans ledit jeu de symboles de données ;
- un moyen pour mettre à jour le nombre maximal possible de symboles de données de valeur nulle dans ledit jeu de symboles de données en relation avec le décodage d'un mot de code reçu pour récupérer une paire de symboles de données représentée par ledit mot de code en soustrayant ledit nombre associé de symboles de données de valeur nulle précédents ou suivants dudit nombre maximal possible de symboles de données de valeur nulle pour donner un nombre maximal possible mis à jour de symboles de données de valeur nulle, où ledit moyen pour décoder un mot de code est agencé pour adapter l'opération de mise en correspondance inverse par laquelle un mot de code ultérieur est décodé pour récupérer une paire de symboles de données représentée par ledit mot de code ultérieur en fonction dudit nombre maximal possible mis à jour de symboles de données de valeur nulle.

**29.** Décodeur selon la revendication 28, **caractérisé en ce qu'**il est agencé pour recevoir une indication d'un nombre de symboles de données de valeur non nulle dans ledit jeu de symboles de données.

**30.** Décodeur selon la revendication 28 ou 29, **caractérisé en ce qu'**il est agencé pour déterminer le nombre maximal possible de symboles de données de valeur nulle dans ledit jeu de symboles de données en soustrayant le nombre de symboles de données de valeur non nulle dans ledit jeu de symboles de données du nombre total de symboles de données dans ledit jeu.

**31.** Décodeur selon la revendication 29 ou 30, **caractérisé en ce qu'**il est agencé pour recevoir ladite indication du nombre de symboles de données de valeur non nulle dans ledit jeu de symboles de données à partir d'un dispositif d'encodage correspondant.

**32.** Décodeur selon l'une quelconque des revendications 28 à 31, **caractérisé en ce que** ledit moyen pour décoder un mot de code est agencé pour effectuer ladite opération de mise en correspondance inverse en sélectionnant une table de mise en correspondance inverse particulière à partir d'un jeu de tables de mise en correspondance inverse en fonction au moins en partie dudit nombre maximal possible de symboles de données de valeur nulle dans ledit jeu de symboles de données, chaque table de mise en correspondance inverse dudit jeu définissant une attribution de mots de code à des symboles de données.

**33.** Décodeur selon la revendication 32, **caractérisé en ce que** chacune desdites tables de mise en correspondance inverse définit une attribution de mots de code à des paires de symboles de données.

**34.** Décodeur selon la revendication 32, **caractérisé en ce que** ledit moyen pour décoder un mot de code est agencé pour décoder un mot de code reçu pour récupérer un numéro de code, et pour utiliser ledit numéro de code comme référence dans la table de mise en correspondance inverse particulière sélectionnée en fonction au moins en partie dudit nombre maximal possible de symboles de données de valeur nulle dans ledit jeu de symboles de données, récupérant ainsi une paire de symboles de données.

**35.** Décodeur selon l'une quelconque des revendications 28 à 34, **caractérisé en ce que** ledit jeu de symboles de données est représentatif de valeurs de coefficient de transformée.

**36.** Décodeur vidéo comprenant un décodeur selon l'une quelconque des revendications 28 à 35.

**37.** Terminal multimédia comprenant un encodeur vidéo selon la revendication 27.

**38.** Terminal multimédia comprenant un décodeur vidéo selon la revendication 36.

**39.** Terminal multimédia selon la revendication 37 ou 38, **caractérisé en ce qu'**il comprend un moyen pour former un lien sans fil avec un réseau de radiocommunication.

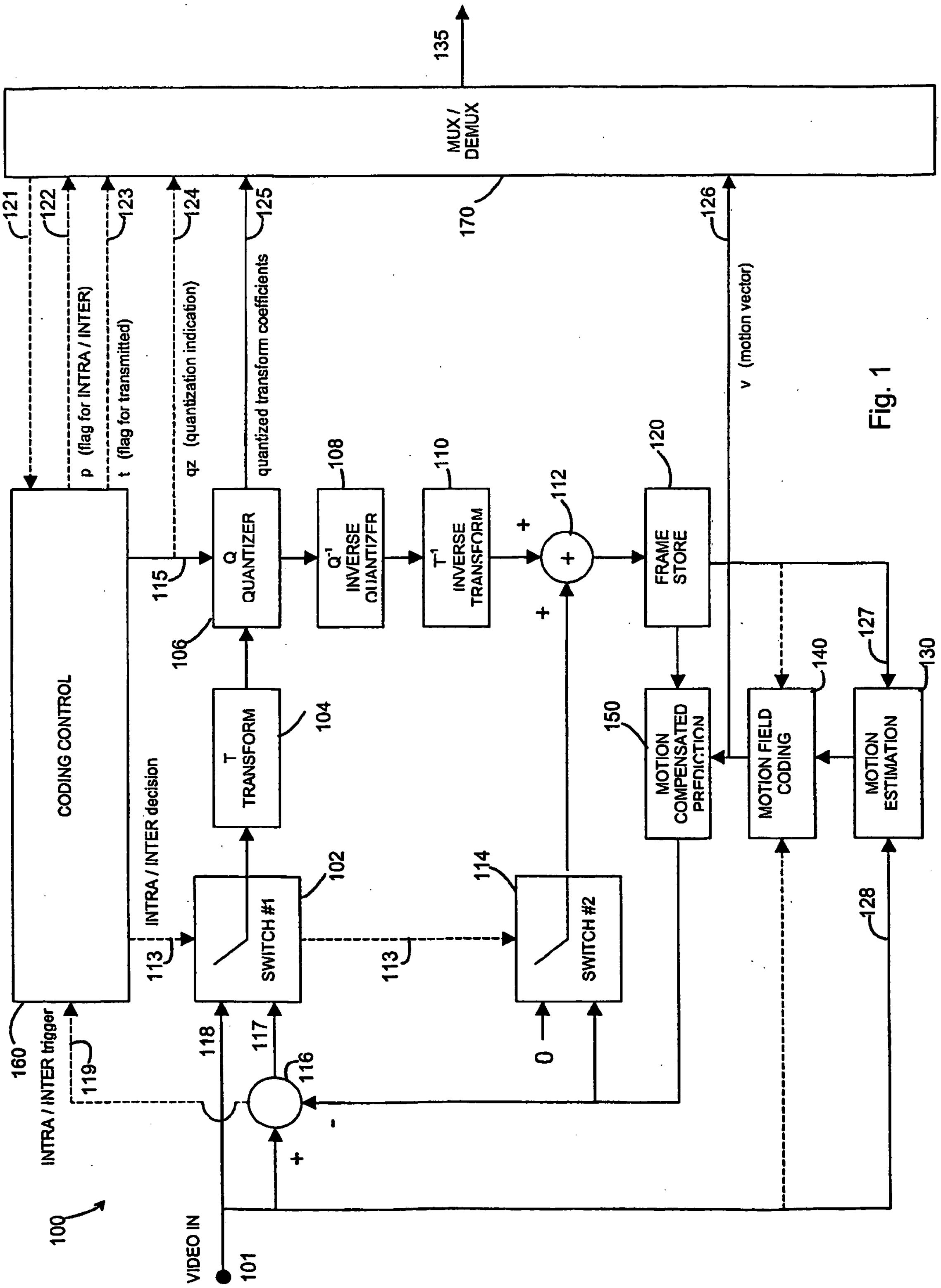
MUX / DEMUX
135
170
121
122
123
124
125
126
p (flag for INTRA / INTER)
t (flag for transmitted)
qz (quantization indication)
quantized transform coefficients
v (motion vector)
CODING CONTROL
160
Q QUANTIZER
106
115
$Q^{-1}$ INVERSE QUANTIZER
108
$T^{-1}$ INVERSE TRANSFORM
110
112
FRAME STORE
120
T TRANSFORM
104
MOTION COMPENSATED PREDICTION
150
MOTION FIELD CODING
140
MOTION ESTIMATION
130
127
128
SWITCH #1
102
SWITCH #2
114
INTRA / INTER decision
113
INTRA / INTER trigger
119
118
117
116
0
VIDEO IN
101
100

Fig. 1

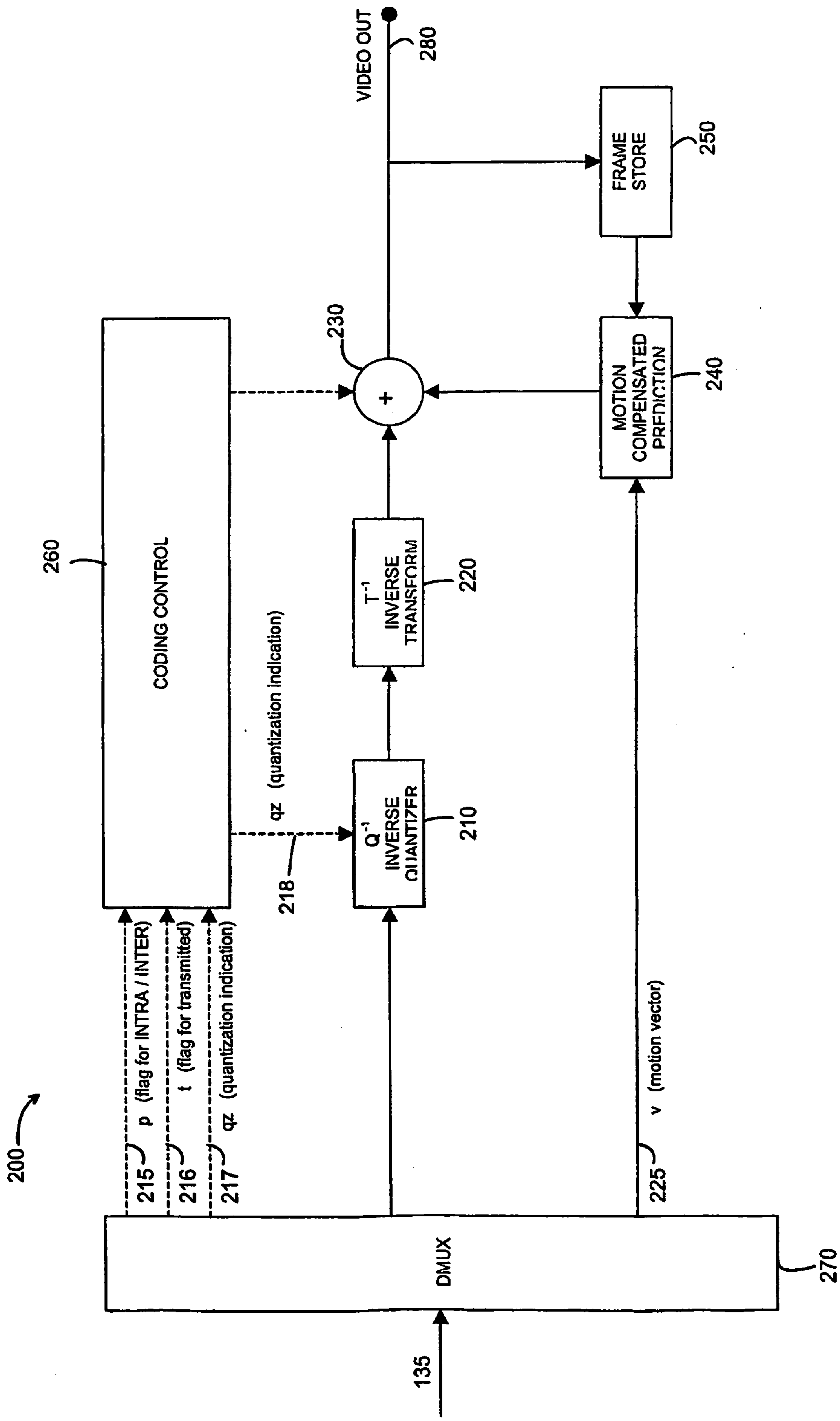
200
VIDEO OUT
280
FRAME STORE
250
CODING CONTROL
260
+
230
MOTION COMPENSATED PREDICTION
240
T-1 INVERSE TRANSFORM
220
Q-1 INVERSE QUANTIZER
210
qz (quantization indication)
218
215 p (flag for INTRA / INTER)
216 t (flag for transmitted)
217 qz (quantization indication)
225 v (motion vector)
DMUX
270
135

Fig. 2

Figure 3a

Figure 3b

Figure 3c

macroblock

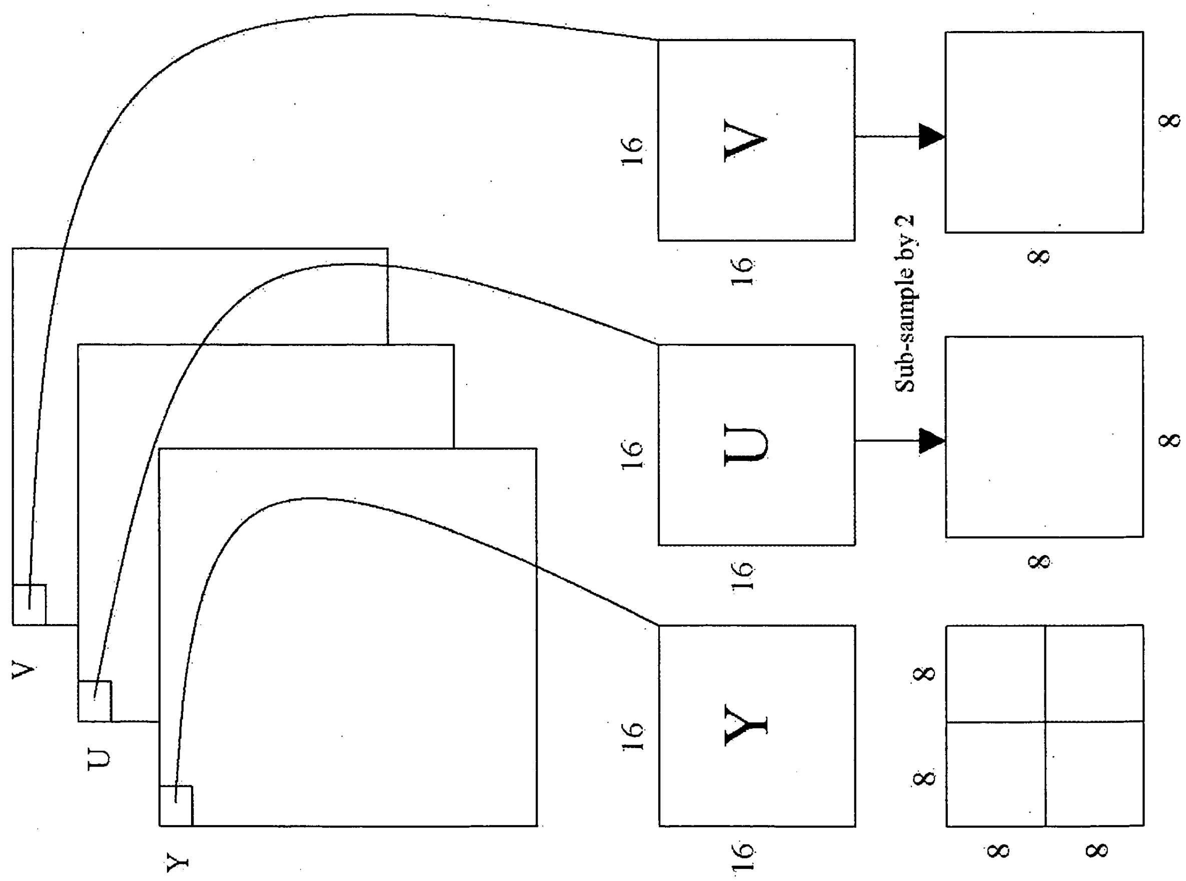

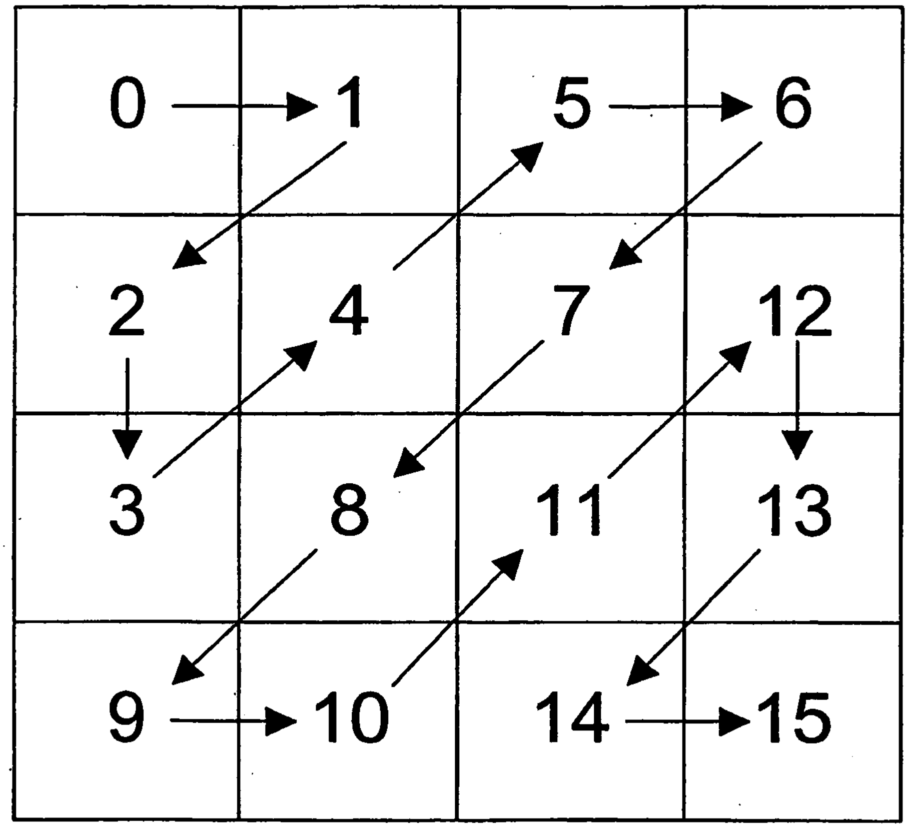


Figure 4

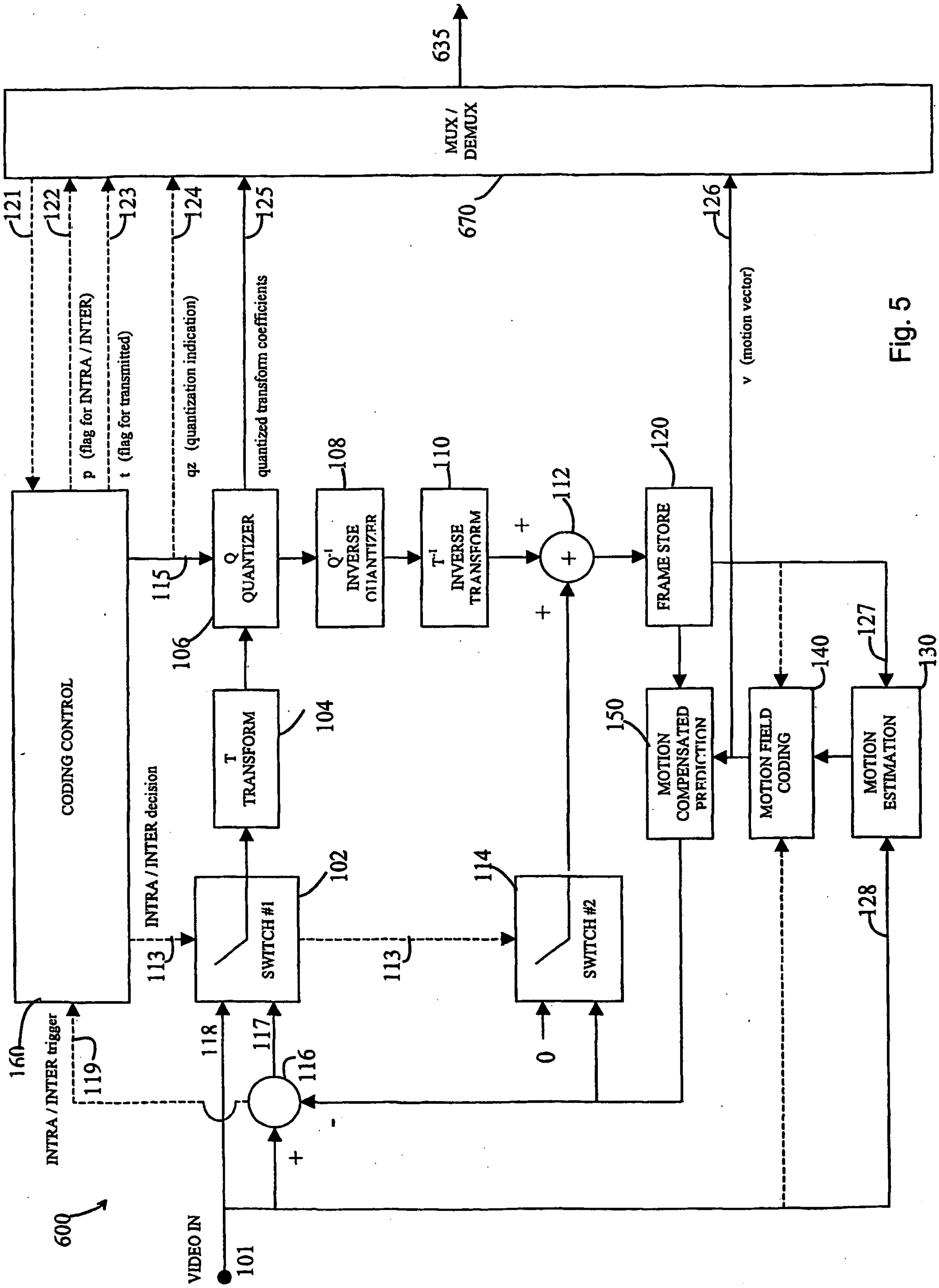
MUX / DEMUX
635
670
121
122
123
124
125
126
p (flag for INTRA / INTER)
t (flag for transmitted)
qz (quantization indication)
quantized transform coefficients
v (motion vector)
CODING CONTROL
160
INTRA / INTER trigger
119
INTRA / INTER decision
113
115
Q QUANTIZER
106
$Q^{-1}$ INVERSE QUANTIZER
108
$T^{-1}$ INVERSE TRANSFORM
110
112
FRAME STORE
120
T TRANSFORM
104
SWITCH #1
102
SWITCH #2
114
0
MOTION COMPENSATED PREDICTION
150
MOTION FIELD CODING
140
MOTION ESTIMATION
130
127
128
116
117
118
VIDEO IN
101
600

Fig. 5

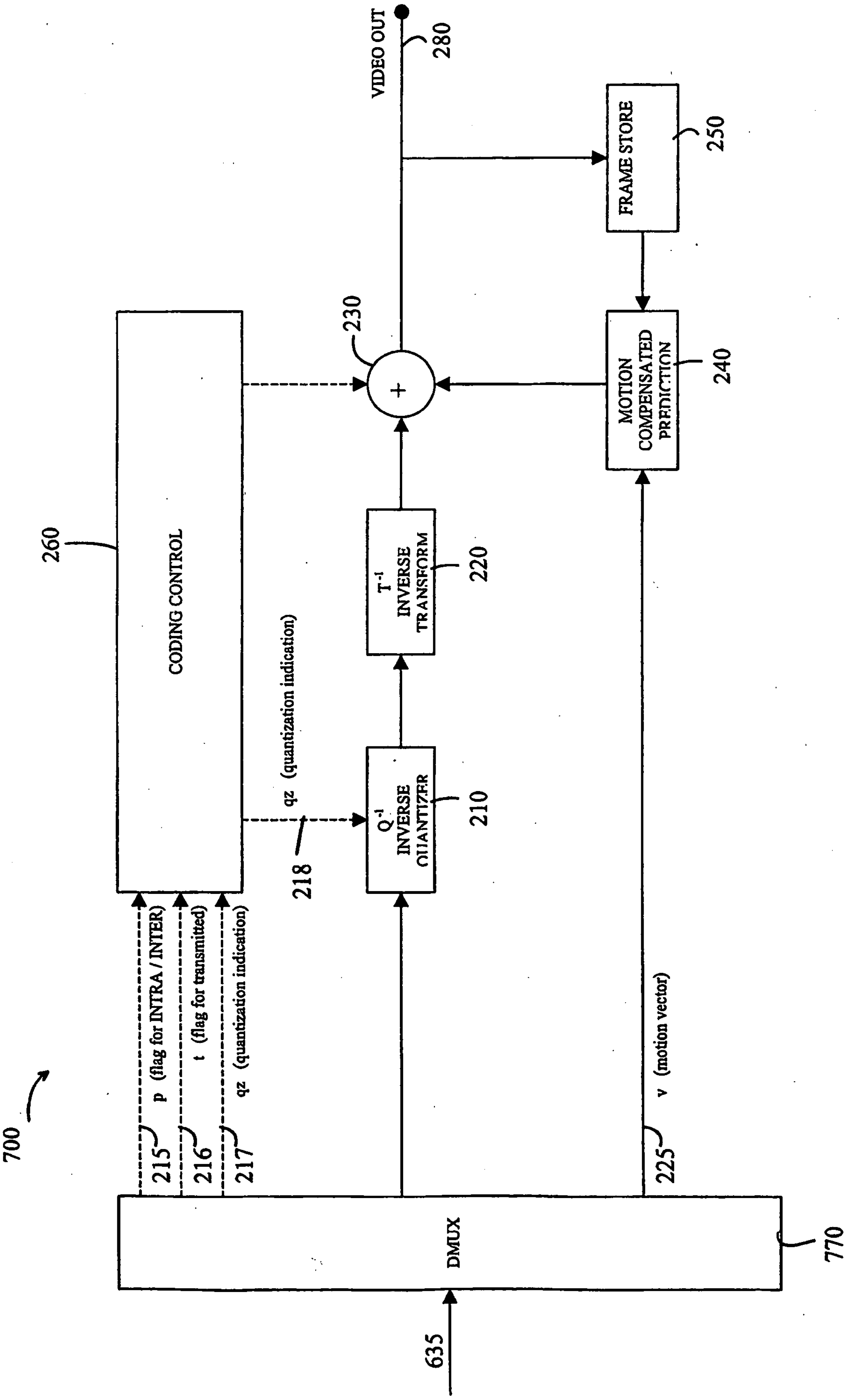
700
VIDEO OUT
280
FRAME STORE
250
CODING CONTROL
260
230
+
MOTION COMPENSATED PREDICTION
240
$T^{-1}$ INVERSE TRANSFORM
220
$Q^{-1}$ INVERSE QUANTIZER
210
qz (quantization indication)
218
p (flag for INTRA / INTER)
t (flag for transmitted)
qz (quantization indication)
215
216
217
v (motion vector)
225
DMUX
770
635

Fig. 6

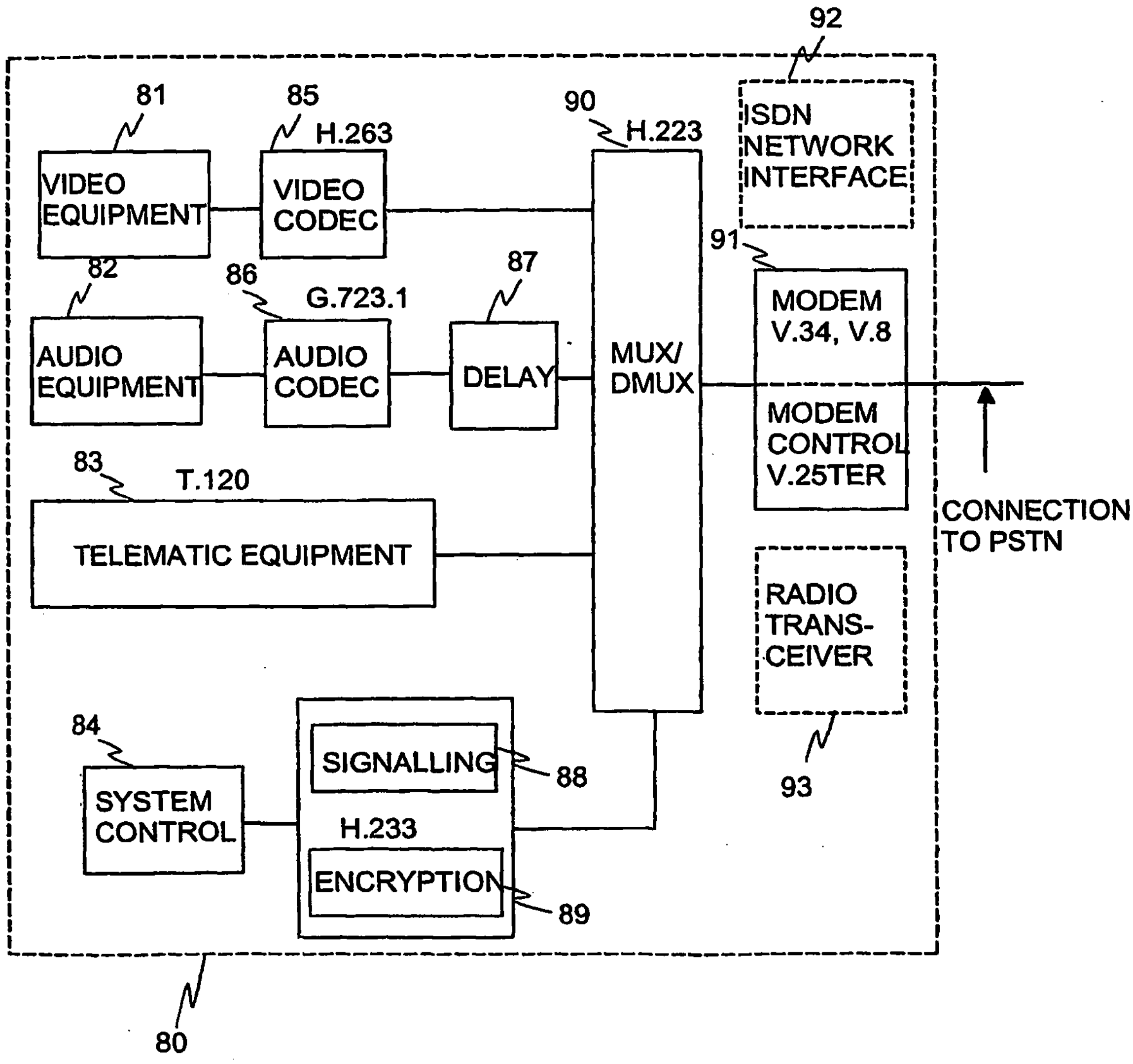
92
81
85
H.263
90
H.223
ISDN
NETWORK
INTERFACE
VIDEO
EQUIPMENT
VIDEO
CODEC
91
82
86
G.723.1
87
MODEM
V.34, V.8
AUDIO
EQUIPMENT
AUDIO
CODEC
DELAY
MUX/
DMUX
MODEM
CONTROL
V.25TER
83
T.120
CONNECTION
TO PSTN
TELEMATIC EQUIPMENT
RADIO
TRANS-
CEIVER
84
SIGNALLING
88
93
SYSTEM
CONTROL
H.233
ENCRYPTION
89
80

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **Karczewicz.** VLC Coefficients Coding for High Bit-Rate. *Doc. JVT-B072, 2nd JVT Meeting,* 29 January 2002
- **Kurceren R. et al.** New Results on Improved CABAC. *Doc, JVT-B101, 2nd Meeting,* 29 January 2002